# EUROPEAN PATENT SPECIFICATION

(11) **EP 3 872 878 B1**
(45) Date of publication and mention of the grant of the patent: **19.04.2023**
(21) Application number: 19888813.3
(22) Date of filing: 26.11.2019
(51) Int. Cl.: H01L 41/053, H01L 41/047, H01L 41/113, G01C 19/5628, G01C 19/5607, G01C 19/5733

(54) **MULTI-AXIAL ANGULAR VELOCITY SENSOR**
MEHRACHSIGER WINKELGESCHWINDIGKEITSSENSOR
CAPTEUR DE VITESSE ANGULAIRE MULTI-AXIAL

(30) Priority: 30.11.2018 JP 2018224672
(43) Date of publication of application: 01.09.2021
(73) Proprietor: Kyocera Corporation, Kyoto-shi, Kyoto 612-8501 (JP)
(72) Inventor: SOEJIMA, Munetaka, Kyoto-shi, Kyoto 612-8501 (JP); TAKANAMI, Shun, Kyoto-shi, Kyoto 612-8501 (JP)
(74) Representative: Viering, Jentschura & Partner mbB Patent- und Rechtsanwälte
(86) International application number: PCT/JP2019/046103
(87) International publication number: WO 2020/111041

(56) References cited:
- WO-A1-2018/021167
- WO-A1-2019/240176
- JP-A- 2000 074 673
- JP-A- 2006 010 659
- JP-A- 2006 010 659
- JP-A- 2007 322 295
- JP-A- 2008 185 343
- JP-A- 2013 238 437
- JP-A- 2016 031 270

## Description

### Technical Field

The present disclosure relates to a multi-axial angular velocity sensor.

### Background Art

Known in the art is a multi-axial angular velocity sensor which is able to detect the angular velocity about each of 2 axes or 3 axes perpendicular to each other (for example Patent Literatures 1 to 3). The multi-axial angular velocity sensor is for example configured by a plurality of sensor elements which detect the angular velocities for mutually different axes mounted in one package. As the sensor elements, for example, piezoelectric vibration type ones are utilized. A piezoelectric vibration type sensor for example has a piezoelectric body having a plurality of arms, excitation electrodes positioned in portions of the plurality of arms, and detecting electrodes positioned in other portions of the plurality of arms.

Patent Literature 1 discloses a multi-axial angular velocity sensor in which three sensor elements having directions of extension of the arms as long directions are arranged in one line in a direction perpendicular to the directions of extension of the arms with orientations by which the directions of extension of the arms become parallel to each other. Further, Patent Literature 1 discloses also that the three sensor elements may be arranged in an L-shape. In Patent Literature 1, the shape of package in which these three sensor elements are mounted is not disclosed.

Patent Literature 2 discloses a multi-axial angular velocity sensor having a package which is rectangular when viewed on a plane and three sensor elements which are mounted in the package. The three sensor elements are arranged along the long sides of the package with orientations by which the directions of extension of the arms become parallel to the short sides of the package. The three sensor elements are respectively equal in lengths in the direction of extension of the arms and the lengths in the direction perpendicular to the direction of extension.

Patent Literature 3 discloses a multi-axial angular velocity sensor in which two sensor elements are mounted in a package so that the directions of extension of the arms are perpendicular to each other.
Further exemplary angular velocity sensors are disclosed in JP 2006 010659 A and WO 2019/240176 A1.

### Citation List

### Patent Literature

Patent Literature 1: International Patent Publication No. 2018/021166
Patent Literature 2: International Patent Publication No.
Patent Literature 3: Japanese Patent Publication No. 2013-178264

### Summary of Invention

According to the present invention, a multi-axial angular velocity sensor defined in claim 1 is provided. Exemplary embodiments according to the present invention are defined in the dependent claims.

### Brief Description of Drawings

FIG. 1 is a disassembled perspective view showing a configuration of a multi-axial angular velocity sensor according to an embodiment.
FIG. 2 is a cross-sectional view taken along the II-II line in FIG. 1.
FIG. 3 is a perspective view showing an example of a y-axis element which can be utilized in the multi-axial angular velocity sensor in FIG. 1.
FIG. 4 is a plan view showing the y-axis element in FIG. 3.
FIG. 5A and FIG. 5B are cross-sectional views taken along the Va-Va line and Vb-Vb line in FIG. 4.
FIG. 6 is a plan view showing an example of an x-axis element which can be utilized in the multi-axial angular velocity sensor in FIG. 1.
FIG. 7 is a cross-sectional view taken along the VII-VII line in FIG. 6.
FIG. 8 is a cross-sectional view showing an example of a z-axis element which can be utilized in the multi-axial angular velocity sensor in FIG. 1.
FIG. 9 is a plan view showing an example of coupling of the sensor elements.
FIG. 10 is a view showing a table of combinations of types and arrangements of three sensor elements according to the embodiment.
FIG. 11 is a plan view showing an example of arrangement of conductors in the package in the multi-axial angular velocity sensor in FIG. 1.
FIG. 12 is a plan view showing an example of arrangement of conductors in a lower layer than those in FIG. 11.

### Description of Embodiments

Below, an embodiment according to the present disclosure will be explained with reference to the drawings. The following drawings are schematic ones. Accordingly, sometimes details will be omitted. Further, size ratios and the like will not always coincide with the actual ones. Further, also size ratios among the plurality of drawings will not always coincide with each other.

For the same or similar configurations, sometimes different alphabetic additional notations will be attached such as "first excitation electrode 53A" and "second excitation electrode 53B". Further, in this case, sometimes the configurations will be simply referred to as the "excitation electrodes 53" and will not be differentiated.

In the explanation of the present embodiment, when referring to a "cuboid shape", "rectangle", "polygonal shape", and the like, unless particularly explained otherwise, these shapes may include shapes with corner portions chamfered by flat surfaces (straight lines) or curved surfaces (curves) and shapes with recessed portions (castellation etc.) formed in the corner portions. Further, the shapes of detailed parts such as relatively small projections which project from one side may be ignored. Further, when referring to the "predetermined portions are parallel", naturally, they need not be strictly parallel due to manufacturing error or the like.

When referring to a sensor element detecting the angular velocity or a sensor detecting the angular velocity or the like, the sensor element or sensor only have to have a function as a transducer (sensor in a narrow sense) which transforms angular velocity to an electrical signal. Accordingly, for example, a sensor, including a sensor element, need not have a driving circuit supplying voltage to the sensor element and a detecting circuit processing an electrical signal from the sensor element and the like either. However, in the following explanations, an aspect where the sensor has a driving circuit and detecting circuit etc. will be taken as an example.

### [Multi-Axial Angular Velocity Sensor]

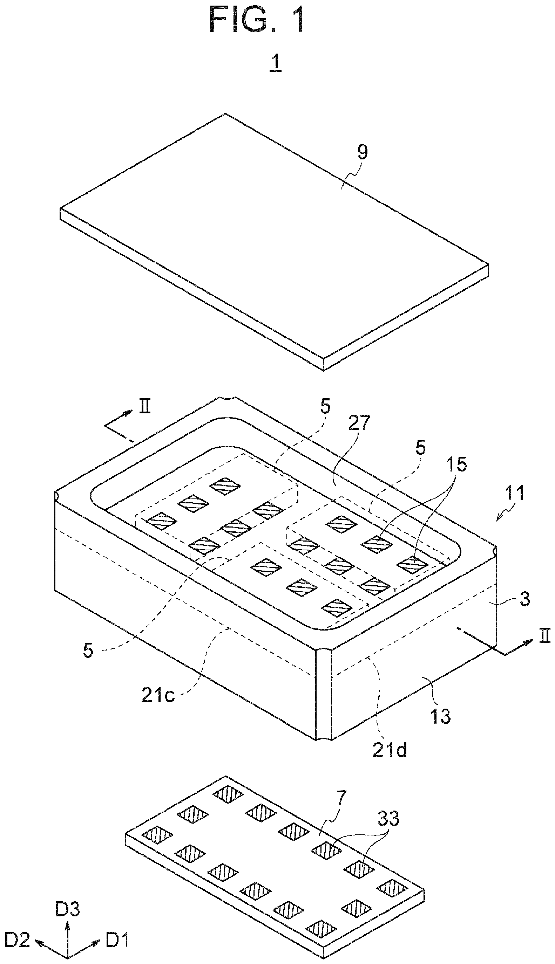

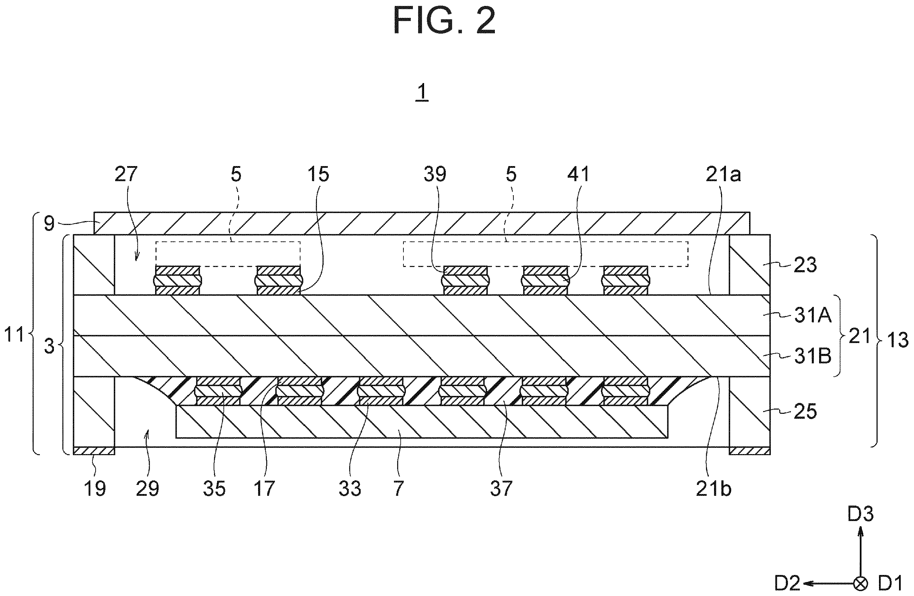

FIG. 1 is a disassembled perspective view showing the configuration of a multi-axial angular velocity sensor 1 (below, sometimes simply referred to as the "sensor 1"). FIG. 2 is a cross-sectional view taken along the II-II line in FIG. 1. However, FIG. 2, for easier illustration, shows a cross-section which is not positioned on the same plane as well.

A D1 axis, D2 axis, and D3 axis which are attached to these views are axes fixed with respect to the multi-axial angular velocity sensor 1 and are perpendicular to each other. The sensor 1 may be utilized when any direction is the upper part. In the following explanations, for convenience, sometimes the "upper surface" and the other terms will be used where the +D3 side is the upper part. Further, when simply referring to the "when viewed on a plane", unless particularly explained otherwise, it designates "viewed from the D3 direction".

The sensor 1 is configured as an electronic part which detects the angular velocity about each of the D1 axis, D2 axis, and D3 axis. The outer shape of the sensor 1 is for example a thin cuboid shape having sides parallel to the D1 axis, D2 axis, and D3 axis. The sensor 1 is for example surface-mounted on the mounting surface of a not shown circuit board so that the surface on the -D3 side faces the mounting surface. The dimensions of the sensor 1 may be suitably set. When explaining one example, the length of one side of the sensor 1 may be made 1 mm to 20 mm.

The sensor 1, as particularly shown in FIG. 1, has a package body 3, three sensor elements 5 which are mounted in the package body 3 from the upper surface side, an IC (integrated circuit) 7 mounted in the package body 3 from the lower surface side, and a lid body 9 sealing the sensor elements 5. The package body 3 and the lid body 9 configure a package 11 of the sensor 1.

As will be understood from the explanations which will be given later, in FIG. 1 and FIG. 2, illustration of detailed parts of the sensor elements 5 is omitted. The sensor elements 5 are schematically shown as thin cuboid shapes. Further, the arrangement of the three sensor elements 5 shown here is only one example of arrangement of the three sensor elements 5 in the present embodiment.

One of the three sensor elements 5 detects the angular velocity about the D1 axis. Another one detects the angular velocity about the D2 axis. Still another one detects the angular velocity about the D3 axis. Due to this, the sensor 1 becomes able to detect the rotation about each of the axes of the D1 axis, D2 axis, and D3 axis. The IC 7 for example inputs driving signals to the three sensor elements 5 and extracts detection signals from the three sensor elements 5. The extracted detection signals are output through the package 11 to an external portion of the sensor 1 (circuit board on which the sensor 1 is mounted).

### (Package Body)

The package body 3 has an insulating body 13 and various conductors which are positioned on the surfaces and/or in an internal portion of the insulating body 13. The various conductors include for example a plurality of pairs of element pads 15 for mounting the sensor elements 5, a plurality of IC pads 17 for mounting the IC 7 (FIG. 2), a plurality of external terminals 19 for mounting the sensor 1 on a not shown circuit board, and a plurality of wiring conductors which connect them to each other (not shown here).

The pluralities of element pads 15 are for example electrically connected through the wiring conductors in the package body 3 with portions of the pluralities of IC pads 17. Other portions of the pluralities of IC pads 17 are for example electrically connected through the wiring conductors in the package body 3 with the plurality of external terminals 19. The wiring conductors in the package body 3 may be suitably configured by layered conductors and/or via conductors which are positioned on the surfaces and/or in the internal portion of the package body 3.

### (Insulating Body)

The insulating body 13, as particularly shown in FIG. 2, has a substrate part 21, a first frame portion 23 positioned on an upper surface 21a of the substrate part 21, and a second frame portion 25 positioned on a lower surface 21b of the substrate part 21. A first recessed portion 27 is formed by the upper surface 21a of the substrate part 21 and the inner circumferential surface of the first frame portion 23. A second recessed portion 29 is formed by the lower surface of the substrate part 21 and the inner circumferential surface of the second frame portion 25. The first recessed portion 27 is air-tightly sealed by the lid body 9.

The substrate part 21 is for example substantially flat plate shaped. That is, the thickness of the substrate part 21 is constant, and the upper surface 21a and lower surface 21b of the substrate part 21 are planar shaped. However, for example, a recessed portion may be formed in the upper surface 21a at a position other than the positions where the element pads 15 are arranged. In other words, the substrate part 21 need not be flat plate shaped either. The recessed portion in the upper surface 21a for example contributes to lowering of the probability of unwanted contact occurring between the sensor element 5 and the upper surface 21a.

The planar shape of the substrate part 21 (upper surface 21a) is rectangular. In more detail, this rectangle has a pair of short sides 21d (indicated by dotted lines in FIG. 1) which are parallel to the D1 axis and a pair of long sides 21c (indicated by dotted lines in FIG. 1) which are parallel to the D2 axis. The ratio of lengths of the long sides 21c and the short sides 21d may be suitably set. For example, the long sides 21c are, with respect to the short sides 21d, 1.1 times or more, 1.3 times or more, or 1.5 times or more. Further, the long sides 21c are, with respect to the short sides 21d, 2.5 times or less, 2 times or less, or 1.8 times or less. The above lower limit and upper limit may be suitably combined.

In the substrate part 21, when the corner portions of the rectangle are chamfered or recessed portions are formed in the corner portions of the rectangle and the like, the lengths of the long sides and short sides may be made lengths obtained by extending the long sides and the short sides until they intersect with each other (lengths when it is assumed that there are no chamfered surfaces and recessed portions). In other words, the lengths of the long sides may be made the distance between the pair of short sides, and the lengths of the short sides may be made the distance between the pair of long sides . The same is true for the other members or portions.

The first frame portion 23 and second frame portion 25 are respectively frame shaped having substantially constant thicknesses. The thickness of the first frame portion 23 may be thinner than, equal to, or thicker than the thickness of the substrate part 21. Further, the thickness of the second frame portion 25 may be thinner than, equal to, or thicker than the thickness of the substrate part 21 and/or first frame portion 23.

In the first frame portion 23 (first recessed portion 27), the shapes (planar shapes) of cross-sections perpendicular to the D3 axis and the dimensions in the cross-sections are substantially the same between the substrate part 21 side (-D3 side) and the opposite side (+D3 side) to that. In the same way, in the second frame portion 25 (second recessed portion 29), the shapes (planar shapes) of cross-sections perpendicular to the D3 axis and the dimensions in the cross-sections are substantially the same between the substrate part 21 side (+D3 side) and the opposite side (-D3 side) to that. However, unlike the example shown, in each of the first frame portion 23 and second frame portion 25, the planar shapes and their dimensions may be different between the substrate part 21 side and the opposite side to that. In this case, the explanation of the planar shapes of the first frame portion 23 and second frame portion 25 and their dimensions in the present disclosure may be applied to both of the substrate part 21 side and the opposite side to that or may be applied to any one of them.

When viewed on a plane, the first frame portion 23 and second frame portion 25 extend along the outer edge of the substrate part 21. From another viewpoint, the shapes of the first frame portion 23 and second frame portion 25 are substantially rectangles each having a pair of long sides and pair of short sides. The outer edges of the first frame portion 23 and second frame portion 25 substantially coincide with (overlap) the outer edge of the substrate part 21. In the first frame portion 23 and second frame portion 25, the width (width of each side) from the inner edge to the outer edge is for example constant in each side. The widths of the four sides may be the same as each other or may be different from each other.

The substrate part 21, first frame portion 23, and second frame portion 25 are for example configured by alumina ceramic or glass ceramic or another ceramic material. The substrate part 21, first frame portion 23, and second frame portion 25 may be configured by the same material or may be configured by mutually different materials. Each of the substrate part 21, first frame portion 23, and second frame portion 25, from the viewpoint of material and/or manufacturing method etc., may be obtained by using one insulation layer or may be obtained by stacking a plurality of insulation layers.

In the example in FIG. 2, the substrate part 21 is configured by a first insulation layer 31A and a second insulation layer 31B stacked on each other. Also, each of the first insulation layer 31A and second insulation layer 31B, from the viewpoint of material and/or manufacturing method etc., may be obtained using one insulation layer or may be obtained by stacking a plurality of insulation layers.

The substrate part 21 and the first frame portion 23 are for example integrally formed. Further, the substrate part 21 and the second frame portion 25 are for example integrally formed. The meaning of "integrally" may for example be that the insulation material configuring the substrate part 21 and the insulation material configuring the first frame portion 23 (or second frame portion 25) directly contact each other and are bonded together. Accordingly, the meaning of the "integrally" does not require that the materials of the two be the same. For example, the substrate part 21 and the first frame portion 23 (and/or second frame portion 25) may be integrally formed by stacking and firing ceramic green sheets having mutually different compositions. The following "integrally" has the same meaning as that described above.

In FIG. 2, the boundaries of the substrate part 21, the first frame portion 23, and the second frame portion 25 are clearly shown. However, these boundaries need not be able to be identified from the viewpoint of materials etc. For example, the substrate part 21, first frame portion 23, and second frame portion 25 may be conceptually defined by the presence of the first recessed portion 27, second recessed portion 29 and/or conductor layers which are interposed among the parts. The same is true for the first insulation layer 31A and second insulation layer 31B.

### (Element Pads)

The pluralities of element pads 15 are configured by conductor layers positioned on the upper surface 21a of the substrate part 21. The material and thickness of the conductor layers may be suitably set. The number of the element pads 15 and the positions on the upper surface 21a may be suitably set in accordance with the configurations and arrangement etc. of the sensor elements 5. The planar shapes of the element pads 15 may be made suitable shapes . For example, they are rectangular shapes. The element pads 15 are basically positioned in a region surrounded by the first frame portion 23 in the upper surface 21a. However, portions may overlap the first frame portion 23 as well.

### (IC Pads)

The IC pads 17 are configured by conductor layers positioned on the lower surface 21b of the substrate part 21. The material and thickness of the conductor layers may be suitably set. The number of the IC pads 17 and the positions on the lower surface 21b may be suitably set in accordance with the configuration and arrangement etc. of the IC 7. The planar shapes of the IC pads 17 may be made suitable shapes. For example, they are rectangular shapes.

### (External Terminals)

The external terminals 19 are configured by conductor layers positioned on the lower surface of the second frame portion 25. The material and thickness of the conductor layers may be suitably set. The number of the plurality of external terminals 19 may be suitably set in accordance with the configuration of the IC 7 and the like. The positions of the plurality of external terminals 19 on the lower surface of the second frame portion 25 may be suitably set. For example, the plurality of external terminals 19 may be arranged at suitable intervals along the edge parts of the lower surface of the second frame portion 25. The planar shapes of the external terminals 19 may be made suitable shapes.

### (Lid Body)

The lid body 9 is for example made of metal. The type of metal may be made a suitable one. For example, use may be made of an alloy containing at least one of iron, nickel, and cobalt. The peripheral portion of the lid body 9 is bonded with the upper surface of the first frame portion 23 over its entire circumference. Due to this, the first recessed portion 27 is sealed. A gas may be enclosed in the first recessed portion 27 or the first recessed portion 27 may be made a vacuum state. The gas may be made for example nitrogen or another inert gas. "Vacuum" in actuality is a state where the pressure is reduced more than the atmospheric pressure.

The lid body 9 and the first frame portion 23 may be bonded by a suitable method. For example, the two are bonded by bonding by seam welding a not shown metal layer provided on the upper surface of the first frame portion 23 and a not shown metal layer provided on the lower surface of the lid body 9.

### (IC and Its Mounting Structure)

The IC 7 is for example formed in a substantially cuboid shape, is accommodated in the second recessed portion 29, and is arranged so as to face the lower surface 21b of the substrate part 21. The IC 7 has a plurality of IC terminals 33 on the surface facing the lower surface 21b. The IC terminals 33 are bonded with the IC pads 17 through conductive bonding materials 35. Due to this, the IC 7 is mounted in the package body 3. The number and arrangement of the IC terminals 33 may be suitably set. The bonding materials 35 are for example configured by solder or a conductive adhesive. The solder may be lead-free solder as well. The conductive bonding material is for example configured by a thermosetting resin including a filler made of metal.

A sealing material 37 (FIG. 2) functioning as underfill may be arranged between the IC 7 and the lower surface 21b of the substrate part 21. The surface on the -D3 side of the sealing material 37 may be positioned to the further -D3 side than the illustrated position as well. For example, the sealing material 37 may cover the +D3 side portions in the side surfaces of the IC 7, entireties of the side surfaces of the IC 7, or the entirety of the IC 7. The sealing material 37 is for example made of a thermosetting resin (for example epoxy resin). The resin may include a filler as well. As the filler, for example, there can be mentioned one having a low thermal expansion coefficient compared with the resin (for example SiO₂).

### (Mounting Structure of Sensor Elements)

The sensor elements 5 are accommodated in the first recessed portion 27 and are arranged so as to face the upper surface 21a of the substrate part 21. The sensor element 5 has a plurality of element terminals 39 (FIG. 2) on the surface facing the upper surface 21a. The element terminals 39 are joined with the element pads 15 through a conductive bonding material 41. Due to this, the sensor elements 5 are mounted in the package body 3. The bonding material 41 is for example configured by solder or a conductive adhesive. The solder and conductive adhesive are as explained in the explanation of the bonding material 35.

### [Configurations of Elements]

The three sensor elements 5 which detect the angular velocities of three mutually different axes can be configured by for example three types of elements having mutually different configurations. Further, if the two sensor elements which are mutually the same type are made different in orientations relative to each other, the angular velocities of two axes can be detected by these two sensor elements. Accordingly, the three sensor elements 5 can be configured by the one type of the two sensor elements and the other type of the one sensor element as well. In the following explanation, first, the three types of sensor elements will be explained, then the method of combination of the same will be explained.

In the following drawings for explaining the sensor elements, for convenience of explanation, orthogonal coordinate systems xyz will be attached. The orthogonal coordinate systems xyz are defined based on the shapes of the sensor elements (piezoelectric bodies). Accordingly, the x-axes, y-axes, and z-axes do not always show an electrical axis, mechanical axis, and optical axis of the crystal.

Further, the orthogonal coordinate systems xyz are fixed with respect to the sensor elements and do not show the orientations of the sensor elements 5 in the package 11. Accordingly, for example, the x-axis attached to a drawing showing one type of sensor element and the x-axis attached to a drawing showing another type of sensor element do not always show the same directions in the package 11. The same is true for the y-axes. However, all sensor elements 5 are mounted in the package 11 so that their +z directions coincide with the +D3 direction.

The relative relationships between the orthogonal coordinate system xyz and the polarization axis (or electrical axis, mechanical axis, and optical axis of the crystal) are for example substantially the same as each other among the three types of elements except for the positive/negative directions of the axes. However, they need not perfectly coincide.

In the explanation of shapes of the members (for example, the shape of the piezoelectric body) etc. in the sensor elements, the shapes concerned with the basic operations will be explained, and sometimes details will be omitted. For example, in the piezoelectric body, explanations of the shape for lowering the probability of short-circuiting of the wirings, shape for reducing influence of residue, and shape for reducing error of vibration are omitted. Accordingly, for example, even if expressed as a "line symmetrical shape", when such detailed parts are considered, the shape need not be line symmetrical. When expressed as a rectangular shape or the like, detailed parts may be ignored as already explained.

In the process of successively explaining the plurality of types of sensor elements, the sensor elements explained later will basically be explained focusing on the differences from the sensor elements explained earlier. Matters not particularly referred to regarding sensor elements explained later may be considered the same as those of the sensor elements explained earlier. Configurations corresponding or similar to each other among three types of sensor elements will for convenience sometimes be assigned the same notations as each other even if there is a difference.

### (y-Axis Element)

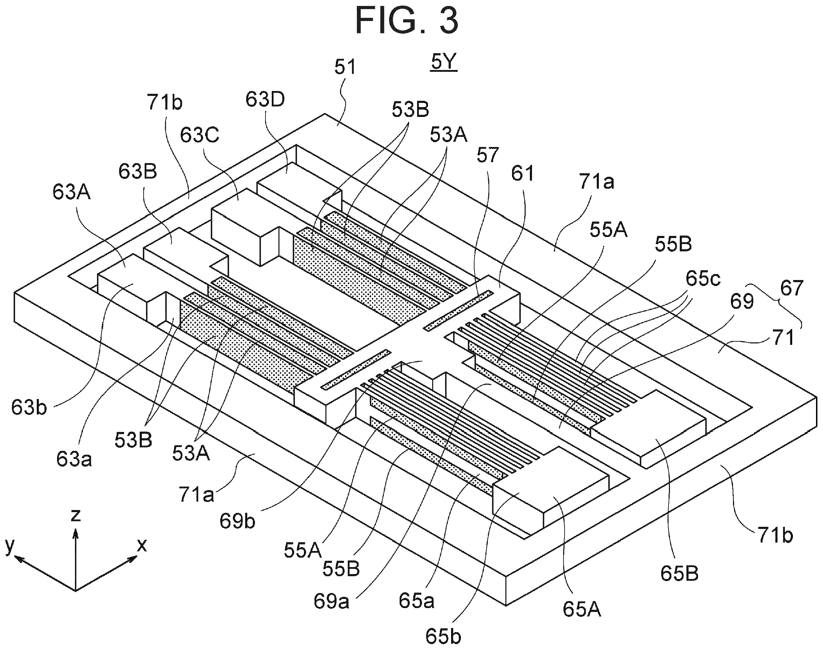

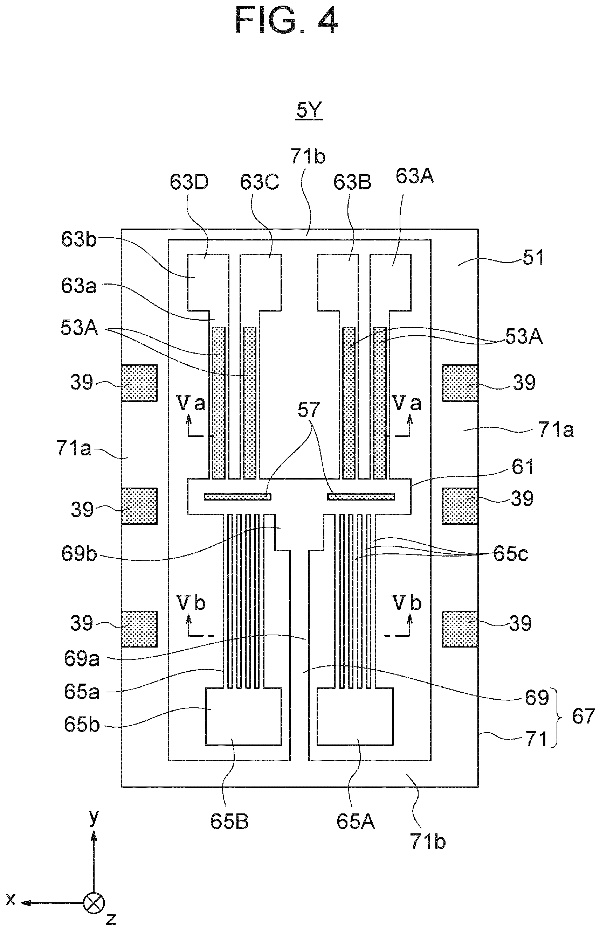

FIG. 3 is a perspective view showing the configuration of a principal part of a y-axis element 5Y of one example of the sensor element 5 detecting rotation about the y-axis. FIG. 4 is a plan view (bottom surface view) showing the configuration of the principal part of the y-axis element 5Y. As described above, the sensor element 5 is mounted so that its +z direction coincides with the +D3 direction, therefore FIG. 4 shows the lower surface of the sensor element 5 (surface facing the upper surface 21a of the substrate part 21).

The y-axis element 5Y is a piezoelectric vibration type. The y-axis element 5Y is excited in the x-direction by utilizing the inverse piezoelectric effect when used. If the y-axis element 5Y is rotated about the y-axis in this state, a Coriolis force in a z-direction is generated, therefore the y-axis element 5Y vibrates in the z-direction with an amplitude in accordance with the angular velocity. By conversion of this vibration to an electrical signal by the piezoelectric effect, the angular velocity is detected.

The basic configuration and operation of the y-axis element 5Y may for example be the same as those of the sensor elements disclosed in Japanese Patent Publication No. 2015-141183 and Japanese Patent Publication No. 2015-141184. Accordingly, the contents of these publications may be incorporated by reference. Further, in the explanation of the y-axis element 5Y, sometimes the explanation of detailed parts will be omitted.

The y-axis element 5Y has a piezoelectric body 51, first excitation electrodes 53A and second excitation electrodes 53B (FIG. 3) for supplying voltages to the piezoelectric body 51, first detecting electrodes 55A (FIG. 3) and second detecting electrodes 55B (FIG. 3) for extracting electrical signals generated in the piezoelectric body 51, reference potential patterns 57 contributing to improvement of isolation between the signals, and already explained element terminals 39 (FIG. 4) for mounting the sensor element 5 in the package body 3.

Additional notations A and B in the excitation electrodes 53 and detecting electrodes 55 are attached based on the orthogonal coordinate system xyz. Accordingly, as will be explained later, one first excitation electrode 53A and the other first excitation electrode 53A do not always have the same potential. The same is true for the second excitation electrodes 53B, first detecting electrodes 55A, and second detecting electrodes 55B.

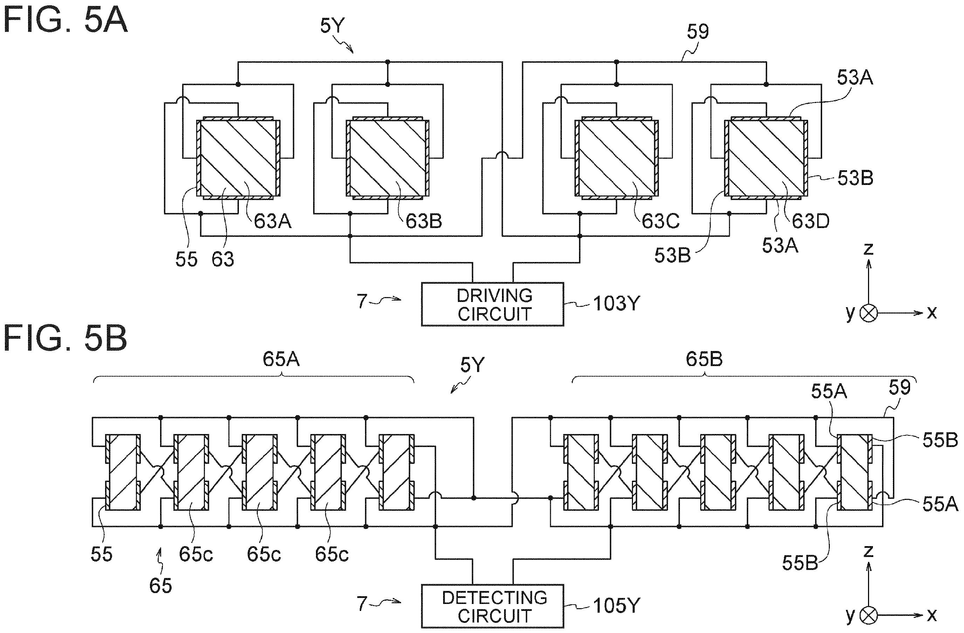

The excitation electrodes 53, detecting electrodes 55, reference potential patterns 57, element terminals 39, and wirings 59 (schematically shown in FIG. 5A and FIG. 5B) which connect them are configured by conductor layers provided on the surface of the piezoelectric body 51. The materials of the same are for example Cu, Al, or another suitable metal. These conductor layers may be configured by stacking layers made of mutually different materials as well.

### (Piezoelectric Body of y-Axis Element)

The piezoelectric body 51 is integrally formed overall. The piezoelectric body 51 may be single crystalline or may be polycrystalline. Further, the material of the piezoelectric body 51 may be suitably selected. For example, it is a quartz crystal (SiO₂), LiTaO₃, LiNbO₃, or PZT.

In the piezoelectric body 51, the electrical axis or polarization axis (below, sometimes only the polarization axis will be referred to as a representative of the two) is set so as to match with the x-axis. The polarization axis may be inclined relative to the x-axis within a predetermined range (for example not more than 15°) as well. Further, in a case where the piezoelectric body 51 is single crystalline, the directions of the mechanical axis and optical axis may be made suitable directions. For example, the mechanical axis is made substantially parallel to the y-axis, and the optical axis is made substantially parallel to the z-axis.

The piezoelectric body 51 is for example made substantially constant in the thickness (z-direction) overall. Further, the piezoelectric body 51 is for example formed in a substantially line symmetrical shape relative to a not shown symmetrical axis parallel to the y-axis. Further, the piezoelectric body 51 includes for example a base part 61, driving arms 63 (first driving arm 63A to fourth driving arm 63D) and detecting arms 65 (first detecting arm 65A and second detecting arm 65B) which extend out of the base part 61, and a support part 67 which supports the base part 61.

A pair of driving arms 63 are excited in the x-direction by application of voltage (electric field). The detecting arms 65 vibrate in the z-direction due to the Coriolis force and generate electrical signals in accordance with the angular velocity. The base part 61 for example contributes to support of the driving arms 63 and detecting arms 65 and transfer of vibrations from the driving arms 63 to the detecting arms 65. The support part 67 for example contributes to support of the base part 61 and mounting of the y-axis element 5Y into the package body 3. The specific configurations are for example as follows.

### (Base Part, Driving Arms, and Detecting Arms in y-Axis Element)

The base part 61 is for example substantially formed in a cuboid shape so as to linearly extend in the x-direction with a constant width.

The plurality of driving arms 63 extend alongside each other (for example in parallel to each other) and along the y-axis (for example in parallel to the y-axis). Their front ends are formed as free ends. The number of the driving arms 63 is for example an even number (four in the present embodiment). The shape of each driving arm 63 when viewed on a plane is for example made a so-called hammer shape. That is, the driving arm 63 has a body portion 63a which extends from the base part 61 to the +y side with a constant width and an extended width portion 63b which is positioned at the front end of the body portion 63a and has a broader width (x-direction) than the body portion 63a. Due to this, the mass of the driving arm 63 is secured at the front end. In turn, it becomes possible to improve the sensitivity and reduce the size. However, the extended width portion 63b need not be provided either.

The direction of extension of the driving arm 63 may be judged using the body portion 63a as the standard. Further, any of two side surfaces (-x side and +x side) of the driving arm 63 may be used as the standard, or the center line may be used as the standard. Projection portions etc. for lowering the probability of short-circuiting of the wirings and other detailed parts or special parts may be ignored as already explained. The same is true for the other arms.

The plurality of detecting arms 65 extend alongside each other (for example in parallel to each other) and along the y-axis (for example parallel to the y-axis) in directions (-y side) opposite to the directions in which the plurality of driving arms 63 extend. Their front ends are formed as free ends. The number of the detecting arms 65 is for example even number (two in the present embodiment). The shape of each detecting arm 65 when viewed on a plane, for example, is made a hammer shape in the same way as the driving arm 63. That is, the detecting arm 65 has a body portion 65a which extends from the base part 61 to the -y side with a constant width and an extended width portion 65b which is positioned at the front end of the body portion 65a and has a broader width (x-direction) than the body portion 65a. Due to this, the mass of the detecting arm 65 is secured at the front end. In turn, it becomes possible to improve the sensitivity and reduce the size. However, the extended width portion 65b need not be provided either.

Each detecting arm 65 (for example the body portion 65a in that) is for example given such a shape that one or plurality of (four in the example shown) slits (notation is omitted) which pass through the detecting arm 65 in the z-direction, and extend in the y-direction are formed. From another viewpoint, each detecting arm 65 has a plurality of (five in the example shown) divided arms 65c extending alongside each other. By the detecting arm 65 having a plurality of divided arms 65c, for example, as will be understood from the explanation which will be given later, the number of the detecting electrodes 55 arranged can be increased, and thereby improve the detection sensitivity.

### (Support Part in y-Axis Element)

The support part 67 for example has a holding portion 69 extending from the base part 61 and a frame portion 71 which is connected to the end part of the holding portion 69 on the opposite side to the base part 61. By the frame portion 71 being fixed to the upper surface 21a of the substrate part 21, the base part 61 is supported through the frame portion 71 and holding portion 69 upon the substrate part 21. The base part 61 is not supported upon the frame portion 71 at two ends of the base part 61, but is supported upon the frame portion 71 through the holding portion 69. Therefore, for example, even if stress is generated in the frame portion 71 due to a thermal expansion difference between the frame portion 71 and the substrate part 21 or the like, it is difficult for the stress to be transferred to the base part 61.

The frame portion 69 for example extends from the base part 61 to the -y side between the pair of detecting arms 65 alongside (for example parallel to) the detecting arms 65. The holding portion 69 is longer than the detecting arms 65 and extends to the further -y side than the front ends of the detecting arms 65. The holding portion 69 for example has a main portion 69a which configures the majority of the holding portion 69 and a connection portion 69b connecting the main portion 69a and the base part 61. The width (x-direction) of the connection portion 69b is made broader than the main portion 69a. Due to this, the strength at the connection portion of the holding portion 69 and the base part 61 is improved.

The frame portion 71 (and its outer edge and inner edge), when viewed on a plane, is a rectangle surrounding the base part 61, driving arms 63, and detecting arms 65. This rectangle has the directions of extension of the driving arms 63 and detecting arms 65 as its long direction. That is, the frame portion 71 has a pair of long sides 71a parallel to the y-axis and a pair of short sides 71b parallel to the x-axis. The holding portion 69 connects the base part 61 and one short side 71b. When viewed on a plane, the outer edge of the frame portion 71 configures the outer edge of the y-axis element 5Y (piezoelectric body 51), therefore the y-axis element 5Y also has the directions of extension of the arms as its long direction.

Whether the long sides 71a and short sides 71b are parallel with respect to the driving arms 63 etc. may be judged based on for example at least one of the outer edges and inner edges of the sides. Further, whether the sides are parallel may be judged using the center lines of the sides as the standard. In the judgment of whether sides are parallel, the small projection portions for lowering the probability of short-circuiting of the wirings and other detailed parts and special parts may be ignored.

The shape of the transverse cross-section of the frame portion 71 (sides) is for example substantially rectangular over the entire length of the frame portion 71. The thickness (z-direction) of the frame portion 71 is for example constant over the entire length of the frame portion 71. The width of the frame portion 71 is for example constant at each side. Further, in the example shown, the width of the short side 71b connected with the holding portion 69 becomes larger than the width of the other short side 71b. However, in the frame portion 71, the width may change in each side or the relative sizes between the widths of the sides may be made different from those described above.

### (Element Terminals in y-Axis Element)

The number of the element terminals 39 may be suitably set in accordance with the configuration of the y-axis element 5Y. The present embodiment illustrates a case where provision is made of six element terminals 39 in total configured by the two element terminals 39 connected to the pluralities of excitation electrodes 53, the two element terminals 39 connected to the detecting electrodes 55, and the two element terminals 39 connected to the reference potential patterns 57.

The element terminals 39 are for example provided on the lower surface (surface on -z side) of the frame portion 71. The positions, shapes, and sizes of the plurality of element terminals 39 when viewed on a plane may be suitably set. In the example shown, three element terminals 39 among the six are arranged on each long side 71a. Further, schematically, they are line symmetrically arranged relative to a not shown center line parallel to the y-axis of the piezoelectric body 51 and relative to a not shown center line parallel to the x-axis of the piezoelectric body 51. Further, the six element terminals 39 are arranged separated from the four corners of the frame portion 71. However, four of the plurality of element terminals 39 may be arranged at the four corners of the frame portion 71 or otherwise the element terminals 39 may be provided in an arrangement different from the illustration.

### (Excitation Electrodes in y-Axis Element)

FIG. 5A is a cross-sectional view taken along the Va-Va line in FIG. 4. As understood from the directions of the x-axes, between FIG. 4 and FIG. 5A, the relationships of the positive/negative directions of the x-axes and the right/left directions on the drawing sheets are inverse.

The excitation electrodes 53 are layered conductors which are formed on the surfaces of the driving arms 63. The first excitation electrodes 53A, in each driving arm 63, are respectively provided on the upper surface and lower surface (+z side surface and -z side surface). On the other hand, the second excitation electrodes 53B, in each driving arm 63, are respectively provided on the side surfaces (+x side surface and -x side surface).

The excitation electrodes 53 are for example provided so as to cover over the majorities of surfaces of the main portion 63a of the driving arm 63 (see FIG. 3 and FIG. 4 as well). However, the first excitation electrodes 53A and the second excitation electrodes 53B are formed so that at least one (first excitation electrodes 53A in the present embodiment) are smaller in the width direction than the surfaces so that they do not short-circuit with each other. Further, portions on the root side and front end side of the body portion 63a may be made positions where no excitation electrodes 53 are arranged.

In each driving arm 63, the two first excitation electrodes 53A are for example rendered the same potentials as each other. For example, the two first excitation electrodes 53A are connected to each other by a wiring 59 on the piezoelectric body 51. Further, in each driving arm 63, the two second excitation electrodes 53B are for example rendered the same potentials as each other. For example, the two second excitation electrodes 53B are connected to each other by a wiring 59 on the piezoelectric body 51.

In such an arrangement and connection relationships of the excitation electrodes 53, when voltage is supplied between the first excitation electrodes 53A and second excitation electrodes 53B, for example, in the driving arm 63, an electric field extending from the upper surface toward the pair of side surfaces (two sides in the x-direction) and an electric field extending from the lower surface toward the pair of side surfaces are generated. On the other hand, the polarization axis matches with the x-direction. Accordingly, when focusing on the components in the x-direction of the electric fields, in the driving arm 63, in one side portion in the x-direction, the orientation of the electric field and the orientation of the polarization axis coincide. In the other side portion, the orientation of the electric field and the orientation of the polarization axis become inverse.

As a result, in the driving arm 63, the one side portion in the x-direction contracts in the y-direction, and the other side portion extends in the y-direction. Further, the driving arm 63 flexes to one side in the x-direction like a bimetal. If the voltage supplied to the first excitation electrodes 53A and the second excitation electrodes 53B is inverted, the driving arm 63 flexes to the inverse direction. If an AC voltage is supplied to the first excitation electrodes 53A and second excitation electrodes 53B, the driving arm 63 vibrates in the x-direction.

Although not particularly shown, in the upper surface and/or lower surface of the driving arm 63, one or more recessed grooves extending along the long direction of the driving arm 63 may be provided, and the first excitation electrodes 53A may be provided over interiors of these recessed grooves. In this case, the first excitation electrodes 53A and the second excitation electrodes 53B face the x-direction sandwiching the wall portion of the recessed groove therebetween. Therefore, the efficiency of excitation is improved. The recessed grooves may be configured by a plurality of recessed portions arranged in the long direction of the driving arm 63 as well.

Between two mutually adjacent driving arms 63 (two of the first driving arm 63A and second driving arm 63B or two of the third driving arm 63C and fourth driving arm 63D), the first excitation electrodes 53A are rendered the same potentials as each other, and the second excitation electrodes 53B are rendered the same potentials as each other. The excitation electrodes 53 which should be rendered the same potentials as each other are for example connected by the wirings 59 on the piezoelectric body 51.

In such connection relationships, if an AC voltage is supplied between the first excitation electrodes 53A and the second excitation electrodes 53B, the two mutually adjacent driving arms 63 are supplied with the voltages having the same phases as each other, therefore vibrate so as to flexurally deform in the same orientations as each other in the x-direction. The two mutually adjacent driving arms 63 may be grasped as parts of one driving arm divided into two. Although not particularly shown, the two mutually adjacent driving arms 63 may be integrally formed at their root portions to form one arm as well.

In a line symmetrically arranged pair of driving arms 63 (pair configured by the first driving arm 63A and fourth driving arm 63D or pair configured by the second driving arm 63B and third driving arm 63C), the first excitation electrodes 53A and the second excitation electrodes 53B are rendered the same potentials. The excitation electrodes 53 which must be rendered the same potentials are for example connected by the wirings 59 on the piezoelectric body 51.

In such connection relationships, if an AC voltage is supplied between the first excitation electrodes 53A and the second excitation electrodes 53B, the line symmetrically arranged pair of driving arms 63 are supplied with voltages having inverse phases to each other, therefore vibrate so as to flexurally deform in inverse orientations (line symmetrically) relative to each other in the x-direction.

### (Detecting Electrodes in y-Axis Element)

FIG. 5B is a cross-sectional view taken along the Vb-Vb line in FIG. 4. As understood from the directions of the x-axes, between FIG. 4 and FIG. 5B, the relationships of the positive/negative directions of the x-axes and right/left directions on the drawing sheets are inverse.

The detecting electrodes 55 are layered conductors which are formed on the surfaces of the detecting arms 65 (divided arms 65c) . The detecting electrodes 55 are provided on each divided arm 65c.

More specifically, the first detecting electrodes 55A, on each division arm 65c, are respectively provided in a +z side region in a -x side surface (for example further more +z side than the center of the surface, the same is true in the following explanation) and a -z side region in a +x side surface. The second detecting electrodes 55B, on each divided arm 65c, are respectively provided in a -z side region in the -x side surface and a +z side region in the +x side surface.

On each side surface of the divided arm 65c, the first detecting electrode 55A and the second detecting electrode 55B extend along the divided arm 65c at a suitable interval so that they do not short-circuit with each other. The detecting electrodes 55 extend over substantially the entire length of the divided arm 65c. In each divided arm 65c, the two first detecting electrodes 55A are connected to each other, and the two second detecting electrodes 55B are connected to each other. They are connected for example by the wirings 59 on the piezoelectric body 51.

In such an arrangement and connection relationships of the detecting electrodes 55, if the divided arm 65c flexurally deforms in the z-direction, for example, an electric field parallel to the z-direction is generated. That is, on each side surface of the divided arm 65c, voltage is generated between the first detecting electrode 55A and the second detecting electrode 55B. The orientations of the electric fields are determined by the orientation of the polarization axis and the orientation of the flex (-z side or +z side) and are inverse to each other between the -x side and the +x side of the divided arm 65c. This voltage (electric field) is output to the first detecting electrodes 55A and second detecting electrodes 55B. When the divided arm 65c vibrates in the z-direction, the voltage is detected as AC voltage. Among the electric fields, the electric field parallel to the z-direction as explained above may be dominant. Otherwise, unlike that explained above, the ratio of the electric fields which are parallel to the x-direction and have orientations inverse to each other between the -z side and the +z side of the divided arm 65c may be larger. In any case, voltage in accordance with the flexural deformation of the divided arm 65c to the z-direction is generated between the first detecting electrodes 55A and the second detecting electrodes 55B.

Between plurality of divided arms 65c in each detecting arm 65, the first detecting electrodes 55A are connected to each other, and the second detecting electrodes 55B are connected to each other. They are connected for example by the wirings 59 on the piezoelectric body 51. In such connection relationships, if the plurality of divided arms 65c flexurally deform so that they flex to the same sides as each other in the z-direction, the signals detected in the plurality of divided arms 65c are added.

Between two detecting arms 65, the first detecting electrode 55A and the second detecting electrode 55B are connected. They are connected for example by the wiring 59 on the piezoelectric body 51. In such a connection relationship, if the two detecting arms 65 flexurally deform so as to flex to the inverse sides to each other in the z-direction, the signals detected in the two detecting arms 65 are added.

### (Reference Potential Patterns in y-Axis Element)

The reference potential patterns 57 are for example mainly positioned in portions (base part 61 and/or support part 67) other than the driving arms 63 and detecting arms 65 in the piezoelectric body 51. Further, the reference potential patterns 57 are for example positioned between wirings having different potentials from each other such as between the wirings 59 connected to the excitation electrodes 53 and the wirings 59 connected to the detecting electrodes 55. Due to this, the isolation between the wirings is improved. The specific shapes of the reference potential patterns 57 may be made for example the wiring shapes. Concerning the reference potential patterns (reference potential wirings), they are disclosed in Japanese Patent Publication No.2015-141183.

### (Wirings in y-Axis Element)

The plurality of wirings 59 connect the excitation electrodes 53 and the detecting electrodes 55 as explained above. Further, the plurality of wirings 59 respectively connect the total four sets of the electrodes, including the two sets of the excitation electrodes 53 grouped from the viewpoint of the potentials and two sets of the detecting electrodes 55 grouped from the viewpoint of the potentials, and the four element terminals 39 (FIG. 4). The reference potential patterns 57 have wiring shaped portions and are connected to the remaining two element terminals 39. Portions of the reference potential patterns 57 may be grasped as wirings 59 as well.

By the plurality of wirings 59, although not particularly shown, being suitably arranged at the upper surfaces, lower surfaces, and/or side surfaces of the various portions in the piezoelectric body 51, the connections explained above can be realized in a manner where the wirings as a whole are provided on the surface of the piezoelectric body 51 without short-circuiting with each other. However, by providing insulation layers on the wirings 59 positioned on the piezoelectric body 51 and providing other wirings 59 on those, three-dimensional wiring portions may be formed as well.

### (Driving Circuit and Detecting Circuit of y-Axis Element)

As shown in FIG. 5A and FIG. 5B, a driving circuit 103Y which supplies voltages (inputs driving signals) to the excitation electrodes 53 is connected to the excitation electrodes 53 through the two element terminals 39. Further, a detecting circuit 105Y detecting electrical signals (detection signals) from the detecting electrodes 55 is connected to the detecting electrodes 55 through the other two element terminals 39. The driving circuit 103Y and detecting circuit 105Y are configured in the IC 7 in the present embodiment. Although not particularly shown, the reference potential is given from the IC 7 to the reference potential patterns 57 through the remaining two element terminals 39.

The driving circuit 103Y, for example, is configured including an oscillation circuit or amplifier and supplies an AC voltage having a predetermined frequency between the first excitation electrodes 53A and the second excitation electrodes 53B. The above frequency may be determined in advance in the IC 7 or may be designated from an external apparatus etc. of the sensor 1.

The detecting circuit 105Y, for example, is configured including an amplifier or wave detecting circuit, detects a potential difference between the first detecting electrode 55A and the second detecting electrode 55B, and outputs an electrical signal in accordance with the detection result to an external apparatus or the like. More specifically, for example, the above potential difference is detected as the AC voltage, and the detecting circuit 105Y outputs a signal in accordance with the amplitude of the AC voltage detected. The angular velocity is identified based on this amplitude. Further, the detecting circuit 105Y outputs a signal in accordance with the phase difference between the supplied voltage of the driving circuit 103Y and the detected electrical signal. The orientation of rotation is identified based on this phase difference.

### (Operation of y-Axis Element)

As explained above, the group of the first driving arm 63A and second driving arm 63B and the group of the third driving arm 63C and fourth driving arm 63D are excited with mutually inverse phases (phases offset by 180°) so as to deform to mutually inverse sides in the excitation direction (x-direction).

In this state, if the sensor element 5 is rotated about the y-axis, the driving arms 63 receive a Coriolis force in a direction (z-direction) perpendicular to the excitation direction (x-direction) and to the direction of the rotation axis (y-direction). Due to this, the driving arms 63 vibrate in the z-direction. Further, the group of the first driving arm 63A and second driving arm 63B and the group of the third driving arm 63C and fourth driving arm 63D are excited with mutually inverse phases, therefore vibrate so as to flex to mutually inverse sides in the z-direction.

The driving arms 63 and the detecting arms 65 are connected by the base part 61. Accordingly, the vibrations of the driving arms 63 are transferred through the base part 61 to the detecting arms 65, and the detecting arms 65 also vibrate. Specifically, the first detecting arm 65A vibrates so as to flex to the inverse side to the first driving arm 63A and second driving arm 63B in the z-direction. Further, the second detecting arm 65B vibrates so as to flex to the inverse side to the third driving arm 63C and fourth driving arm 63D in the z-direction. From another viewpoint, the first detecting arm 65A and the second detecting arm 65B vibrate so as to flex to mutually inverse sides in the z-direction. Accordingly, as explained in the explanation of the connection relationships of the plurality of detecting electrodes 55, the electrical signals generated in the two detecting arms 65 are added.

In the above description, the action of transfer of the vibrations in the z-direction of the driving arms 63 to the detecting arms 65 was explained. In other words, the explanation was given while ignoring the vibrations in the x-direction of the detecting arms 65. In actuality, the vibrations in the x-direction of the driving arms 63 are transferred to the detecting arms 65, the detecting arms 65 vibrate in the x-direction, and a Coriolis force is generated in the detecting arms 65, whereby the action of vibrations of the detecting arms 65 in the z-direction also occurs. Any of these two types of actions may be dominant for the vibrations in the z-direction of the detecting arms 65 as well.

### (x-Axis Element)

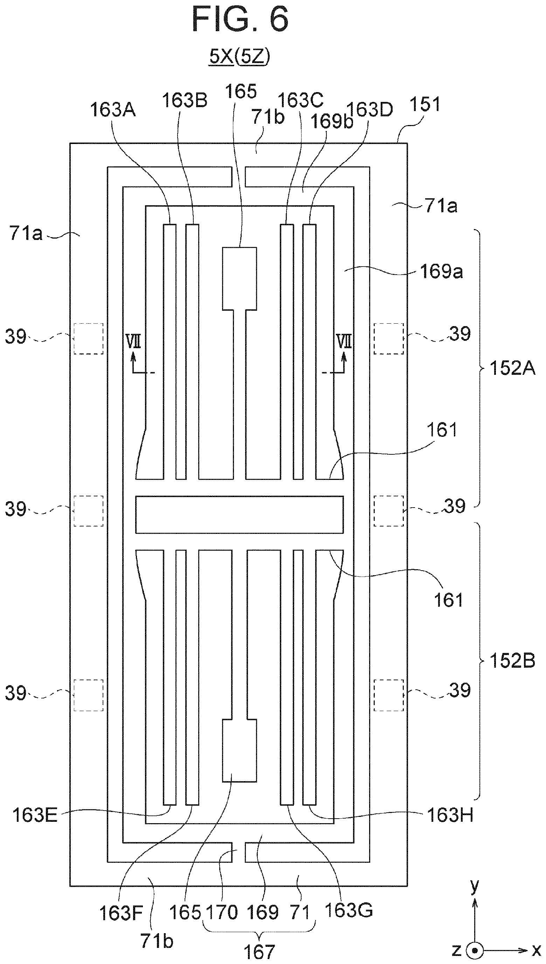

FIG. 6 is a plan view showing the configuration of the principal part in an x-axis element 5X of one example of the sensor element 5 which detects rotation about the x-axis. In this view, however, illustration of the conductive layers provided on the surfaces of the x-axis element 5X is basically omitted.

The x-axis element 5X is a piezoelectric vibration type. The x-axis element 5X is excited in the x-direction by utilizing the piezoelectric effect when used. At this time, by the x-axis element 5X having a special configuration, vibration in the y-direction also arises along with the excitation in the x-direction. If the x-axis element 5X is rotated about the x-axis in this state, Coriolis force in the z-direction is generated and the x-axis element 5X vibrates in the z-direction with an amplitude in accordance with the angular velocity. By this vibration being converted to electrical signals according to the piezoelectric effect, the angular velocity is detected.

The basic configuration and operation of the x-axis element 5X may be for example the same as the sensor elements disclosed in International Patent Publication No. 2018/021166, International Patent Publication No. 2018/021167, and International Patent Publication No. 2018/139396. Accordingly, the contents in these publications may be incorporated by reference. Further, in the explanation of the x-axis element 5X, sometimes an explanation of detailed parts will be omitted.

### (Piezoelectric Body in x-Axis Element)

For the material of the piezoelectric body 151 in the x-axis element 5X and the relative relationships between the polarization axis and the orthogonal coordinate system xyz in the piezoelectric body 151, the explanation of the piezoelectric body 51 in the y-axis element 5Y may be cited. However, between the y-axis element 5Y and the x-axis element 5X which are mounted together in the same package body 3, the materials of the piezoelectric bodies, the directions of the polarization axes, and the like need not coincide with each other. Further, the piezoelectric body 151, in the same way as the piezoelectric body 51, may be made constant in thickness (z-axis direction) as a whole.

The piezoelectric body 151, for example, is substantially formed in a line symmetrical shape relative to a not shown symmetrical axis parallel to the y-axis. Further, the piezoelectric body 151 is for example formed in substantially a line symmetrical shape relative to a not shown symmetrical axis parallel to the x-axis.

The piezoelectric body 151 has two units 152 (152A and 152B) which are line symmetrically arranged sandwiching a not shown symmetrical axis parallel to the x-axis therebetween and a support part 167 supporting these two units 152.

Each unit 152 for example has a base part 161, at least one pair of (two pairs in the example shown) driving arms 163 (163A to 163D or 163E to 163H) and a detecting arm 165 which extend from the base part 161. The unit 152 can detect the angular velocity solely. In the example shown, the piezoelectric body 151 has two units 152. Therefore, for example, by adding the signals of the two, it becomes possible to improve the detection sensitivity.

In each unit 152, the base part 161 for example linearly extends parallel to the x-axis and is supported at the two ends by the support part 167. Although not particularly shown, when viewed on a plane, the two ends of the base part 161 (portions on the sides outside from the positions where the driving arms 163 are arranged) may be formed in L-shapes, Ω-shapes, or S-shapes. That is, the base part 161 may include a portion intersecting with the x-axis at the two ends as well. By forming this in this way, the flexing of the base part 161 which will be explained later is facilitated.

In each unit 152, the four driving arms 163 are the same as the four driving arms 63 in the y-axis element 5Y except for the specific dimensions and specific connection positions with respect to the base part 161. In FIG. 6, the driving arms 163 are not hammer shaped. However, they may be hammer shaped as well in the same way as the driving arms 63. The recessed grooves may be provided in the same way as well. The driving arms 163 extend from suitable positions between the center position in the long direction of the base part 161 and its two ends.

In each unit 152, the detecting arm 165 extends from the center position in the long direction of the base part 161 alongside (for example in parallel to) the plurality of driving arms 163 and along the y-axis (for example in parallel to the y-axis). The detecting arm 165 is the same as the detecting arm 65 in the y-axis element 5Y except for the specific dimensions and the connection position with respect to the base part 161. In FIG. 6, the detecting arm 165 is not hammer shaped and does not have a plurality of divided arms. However, it may also be hammer shaped or have a plurality of divided arms. Further, the detecting arm 165 may be shaped extending outward from the base part 161 in parallel to the y-axis, then turning back to the base part 161 side (see International Patent Publication No. 2018/139396) as well.

The support part 167 has an inner side frame portion 169 which support the two units 152, projection portions 170 projecting from the inner side frame portion 169 to the outer sides thereof, and a frame portion 71 supporting the inner side frame portion 169 through the projection portions 170. The frame portion 71 is a portion corresponding to the frame portion 71 in the y-axis element 5Y, therefore the explanation is omitted.

The inner side frame portion 169 (and its outer edge and inner edge), for example, when viewed on a plane, is substantially rectangular shaped so as to surround the base parts 161, driving arms 163, and detecting arms 165. This rectangle has the directions of extension of the driving arms 163 and detecting arms 165 as the long direction. That is, the inner side frame portion 169 has a pair of long sides 169a parallel to the y-axis and a pair of short sides 169b parallel to the x-axis. The base parts 161 extend between the pair of long sides 169a. The shape of the transverse cross-section of each side may be suitably set. In the example shown, the long sides 169a are narrower in widths at the connection portions with the base parts 161.

The projection portions 170 for example connect the short sides 169b in the inner side frame portion 169 and the short sides 71b in the frame portion 71 which are parallel to each other. The projection portions 170 are for example positioned at the centers in the long direction in the short sides 169b and short sides 71b. Two projection portions 170 are provided corresponding to the pair of short sides 169b. However, a projection portion 170 may be provided only with respect to one short side 169b as well.

### (Conductors in x-Axis Element)

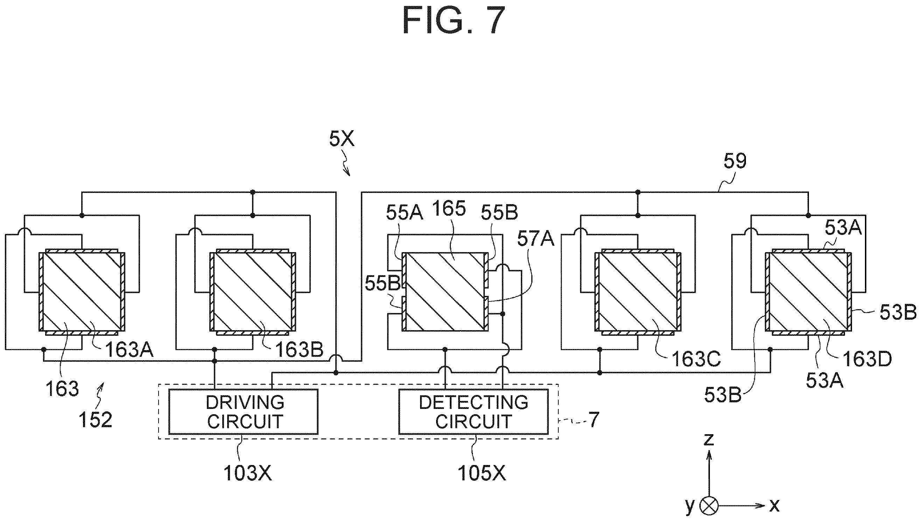

FIG. 7 is a cross-sectional view taken along the VII-VII line in FIG. 6. In this view, a cross-sectional view of the unit 152A is shown, but the same is true for the cross-sectional view of the unit 152B.

The configurations and arrangement of the excitation electrodes 53 in each driving arm 163 are the same as those in the first embodiment. Accordingly, by AC voltage being supplied to the first excitation electrodes 53A and second excitation electrodes 53B, the driving arm 163 vibrates in the x-axis direction. Between the units 152A and 152B, the orientations in which the driving arms 163 extend are inverse to each other. However, in any case, the additional notation A of the excitation electrode 53 corresponds to the upper surface or lower surface of the driving arm 163, and the additional notation B of the excitation electrode 53 corresponds to the side surfaces of the driving arm 163.

The configurations and arrangement of the detecting electrodes 55 in each detecting arm 165 are the same as those in the y-axis element 5Y except for the detecting electrodes 55 not being provided for each divided arm. Accordingly, by the first detecting electrodes 55A and second detecting electrodes 55B, signals generated by vibration in z-axis direction of the detecting arm 165 are detected. Between the units 152A and 152B, the orientations of extension of the detecting arms 165 are inverse to each other. In any case, however, the additional notation A of the detecting electrode 55 corresponds to the +z region in the -x side surface and to the -z region in the +x side surface, while the additional notation B of the detecting electrode 55 corresponds to the -z region in the -x side surface and to the +z region in the +x side surface.

In each unit 152, the potentials (from another viewpoint, connection relationships) of the plurality of excitation electrodes 53 in the two pairs of driving arms 163 are the same as those in the y-axis element 5Y. Accordingly, the two pairs of driving arms 163 in each unit 152 are excited in the same way as those in the y-axis element 5Y.

Concerning the two units 152, among the driving arms 163 which are positioned on the same side in the x-axis direction relative to the detecting arm 165 (among 163A, 163B, 163E, and 163F, or among 163C, 163D, 163G, and 163H), the first excitation electrodes 53A are rendered the same potentials as each other, and the second excitation electrodes 53B are rendered the same potentials as each other. The excitation electrodes 53 which should be rendered the same potentials are for example connected to each other by the plurality of wirings 59 on the piezoelectric body 151. Accordingly, in the two units 152, the plurality of driving arms 163 approach or are separated from the detecting arm 165 side with mutually the same phases.

Further, between the detecting arms 165 in the two units 152, the first detecting electrodes 55A and the second detecting electrodes 55B are rendered the same potentials. The detecting electrodes 55 which should be rendered the same potentials are for example connected to each other by the plurality of wirings 59 on the piezoelectric body 151. Accordingly, when the two detecting arms 165 flex to the inverse sides to each other in the z-axis direction, the signals generated in the two are added.

Although not particularly shown, in the x-axis element 5X as well, provision is made of the reference potential patterns 57. The reference potential patterns 57, in the same way as those in the y-axis element 5Y, are mainly positioned in the piezoelectric body 151 in the portions (base parts 161 and/or support part 167) other than the driving arms 163 and detecting arms 165 and positioned between the wirings which are different in potentials from each other.

In the above way, the total four sets of the groups of electrode, including the two sets of the excitation electrodes 53 grouped from the viewpoint of the potentials and the two sets of the detecting electrodes 55 grouped from the viewpoint of the potentials, are connected with the four element terminals 39 by the plurality of wirings 59 on the piezoelectric body 151. The reference potential patterns 57 are connected to the remaining two element terminals 39. The element terminals 39 are the same as those in the y-axis element 5Y, therefore the explanation for the element terminals 39 in the y-axis element 5Y may be cited for the element terminals 39 in the x-axis element 5X. The six element terminals 39 are connected to the driving circuit 103X and detecting circuit 105X in the IC 7.

### (Operation in x-Axis Element)

In each unit 152, the excitations of the plurality of driving arms 163 are the same as those of the plurality of driving arms 63 in the y-axis element 5Y. That is, the driving arms 163 on the two sides sandwiching a detecting arm 165 therebetween are excited with mutually inverse phases so as to deform in mutually inverse orientations in the x-axis direction by application of AC voltage to the excitation electrodes 53.

At this time, if the driving arms 163 on the two sides of a detecting arm 165 flex to the sides away from the detecting arm 165 in the x-axis direction, that bending moment is transferred to the base part 161. Further, the base part 161 flexes in the y-axis direction to the sides in which the driving arms 163 extend (+y side in the unit 152A and -y side in the unit 152B) . As a result, the detecting arms 165 displace in the y-axis direction to the sides to which the driving arms 163.

Conversely, if the driving arms 163 on the two sides of a detecting arm 165 flex to the sides approaching the detecting arm 165, that bending moment is transferred to the base part 161, and the base part 161 flexes to the opposite side to the side from which the driving arms 163 extend. As a result, the detecting arm 165 displaces to the opposite side to the side from which the driving arms 163 extend.

Accordingly, by the driving arms 163 on the two sides of the detecting arm 165 being excited, the detecting arm 165 vibrates in the y-axis direction. Further, between the two units 152, the plurality of driving arms 163 are excited with the mutually same phases (phases making them separate from or approach the detecting arms 165 in the same way), therefore the two detecting arms 165 vibrate so as to displace to the inverse sides to each other in the y-axis direction.

In the state where the piezoelectric body 151 is vibrating as described above, if the x-axis element 5X is rotated about the x-axis, the detecting arms 165 vibrate (deform) in the z-axis direction due to the Coriolis force since they vibrate (displacing) in the y-axis direction. The signals (for example voltages) generated by this deformation are extracted by the detecting electrodes 55 as explained above. Further, the two detecting arms 165 vibrate with phases displacing to the inverse sides to each other in the y-axis direction, therefore vibrate so as to bend to the inverse sides to each other in the z-axis direction. Further, as explained above, between the two detecting arms 165, the first detecting electrodes 55A and the second detecting electrodes 55B are connected, therefore the signals generated in the two detecting arms 165 are added.

### (z-Axis Element)

FIG. 6 may also be grasped also as a plan view showing a z-axis element 5Z of one example of the sensor element 5 detecting rotation about the z-axis as shown by the parenthesized notation 5Z.

The z-axis element 5Z is piezoelectric vibration type. The z-axis element 5Z is excited in the same way as the x-axis element 5X whereby the detecting arms 165 vibrate (displace) in the y-direction. If the z-axis element 5Z is rotated about the z-axis in this state, a Coriolis force in an x-direction is generated, therefore the detecting arms 165 vibrate in the x-direction with amplitudes in accordance with the angular velocity. The z-axis element 5Z differs from the x-axis element 5X in the configurations of the detecting electrodes etc., therefore becomes able to output electrical signals generated by vibrations of the detecting arms 165 in the x-direction.

The basic configuration and operation of the z-axis element 5Z may be made for example the same as the sensor elements disclosed in International Patent Publication No. 2018/021166 and International Patent Publication No. 2018/021167. Accordingly, the contents in these publications may be incorporated by reference. Further, in the explanation of z-axis element 5Z, sometimes explanation of detailed parts will be omitted.

The basic configuration of the z-axis element 5Z may be made the same as the basic configuration of the x-axis element 5X except for the detecting electrodes (and wirings 59 concerning them) . Accordingly, the explanation of the x-axis element 5X may be cited for the z-axis element 5Z. However, in the z-axis element 5Z, the detecting arms 165, unlike the x-axis element 5X, are meant to vibrate in the x-axis direction by the Coriolis force. Based on such a difference, specific dimensions and/or shapes of the detecting arms 165 etc. may be different from those in the x-axis element 5X.

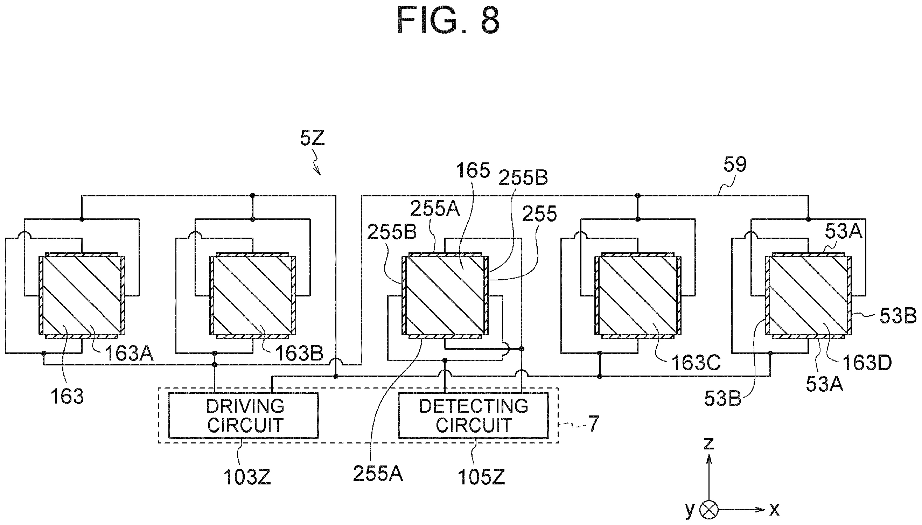

FIG. 8 is a cross-sectional view showing a portion of the z-axis element 5Z and corresponding to FIG. 7.

The first detecting electrodes 255A and the second detecting electrodes 255B are ones extracting signals generated due to bending deformation in the x-axis direction of the detecting arms 165. Therefore, for example, the electrodes are given the same configurations as the excitation electrodes 53 for exciting the driving arms 163 in the x-axis direction. Accordingly, the explanation for the excitation electrodes 53 may be cited for the detecting electrodes 255 by reading the "excitation electrodes 53" as the "detecting electrodes 255". The same is true for mutual connection of a pair of first detecting electrodes 255A in each detecting arm 165 and mutual connection of a pair of second detecting electrodes 255B.

In the explanations of the y-axis element 5Y and x-axis element 5X, concerning the detecting electrodes 55, the fact that the detecting arms 65 and 165 could have a plurality of divided arms (plurality of slits could be provided) was alluded to. In the z-axis element 5Z, the detecting arms 165, in the same way as the driving arms 63 and 163, may be provided with recessed grooves in their upper surfaces and/or lower surfaces.

Between two detecting arms 165, the first detecting electrodes 255A and the second detecting electrodes 255B are connected. Accordingly, when the two detecting arms 165 bend to inverse sides to each other in the x-axis direction, the signals generated in the detecting arms 165 are added. The detecting electrodes 255 are for example connected by the plurality of wirings 59 on the piezoelectric body 151.

In the same way as the other sensor elements 5, the two sets of excitation electrodes 53 divided from the viewpoint of the potentials are connected through the two element terminals 39 to the driving circuit 103Z in the IC 7. The two sets of detecting electrodes 255 divided from the viewpoint of the potentials are connected through the other two element terminals 39 to the detecting circuit 105Z in the IC 7. The reference potential patterns 57 are connected through the remaining two element terminals 39 to the IC 7.

### (Operation in z-Axis Element)

The excitation state of the z-axis element 5Z is the same as the excitation state of the x-axis element 5X. If the z-axis element 5Z is rotated about the z-axis in this excitation state, the detecting arms 165 vibrate in the x-direction since they vibrate (are displaced) in the y-axis direction. The signals (for example voltages) generated due to this deformation are extracted by the detecting electrodes 255. Further, the two detecting arms 165 vibrate with phases by which they displace to inverse sides to each other in the y-axis direction, therefore they vibrate so as to bend to inverse sides to each other in the x-axis direction. Further, between the two detecting arms 165, the first detecting electrodes 255A and the second detecting electrodes 255B are connected, therefore the signals generated in the two detecting arms 165 are added.

### (Dimensions of Three Sensor Elements)

The various dimensions of the sensor elements 5 may be suitably set in accordance with the frequency set in the sensor elements 5 and the like. However, the sizes of the sensor elements 5 as a whole are set so as not to greatly diverge among the three sensor elements 5.

For example, suppose the smallest rectangles each including each of the sensor elements 5 (piezoelectric bodies from another viewpoint) . In the sensor elements 5 which are illustrated hitherto, the rectangles are oblongs which coincide with the outer edges of the frame portions 71 and has directions parallel to the y-axis as their long directions. The longest one among the long sides in the three sensor elements 5 is for example 1.5 times or less or 1.1 times or less the size of the shortest one among the long sides in the three sensor elements 5. Further, for example, the longest one among the short sides in the three sensor elements 5 is for example 1.7 times or less, 1.5 times or less, or 1.3 times or less the size of the shortest one among the short sides in the three sensor elements 5.

### (Coupling Among Sensor Elements)

In the sensor 1, the three sensor elements 5 may be separated from each other or two or more may be coupled (integrally formed) .

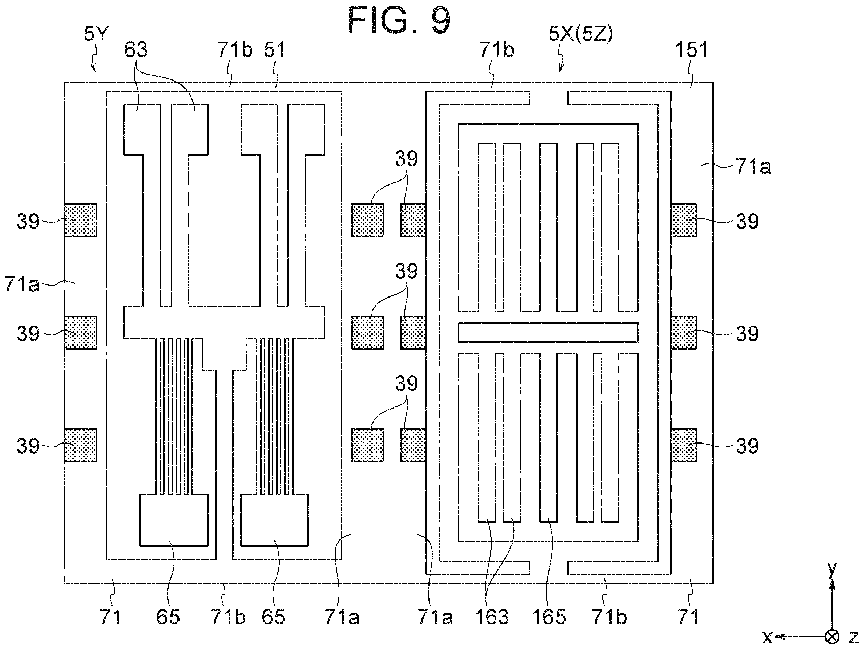

FIG. 9 is a plan view (bottom surface view) showing an example of a mode where two sensor elements 5 are connected. In this view, illustration of the conductors other than the element terminals 39 is omitted.

In this example, the piezoelectric body 51 in the y-axis element 5Y and the piezoelectric body 151 in the x-axis element 5X (or z-axis element 5Z) are integrally formed. For example, the piezoelectric body 51 and the piezoelectric body 151 are prepared together from the same crystal wafer by etching.

Such integral formation may be carried out in any two or more sensor elements 5 among the three sensor elements 5. For example, in the example shown, two sensor elements 5 are integrally formed. However, three sensor elements 5 may be integrally formed as well. Further, in the example shown, the y-axis element 5Y and the x-axis element 5X (or z-axis element 5Z) are integrally formed. Otherwise, for example, the x-axis element 5X and the z-axis element 5Z may be integrally formed.

The parts are for example integrally formed by the outer peripheral portions of the piezoelectric bodies in the sensor elements 5 being connected with each other. Further, the parts are for example integrally formed by the sensor elements 5 being arranged side by side in the direction (short direction) perpendicular to the directions of extension of various types of arms. In the sensor elements 5 illustrated in the present embodiment, the lateral side portions in the short direction of the outer peripheral portions of the piezoelectric body are configured by the long sides 71a in the frame portion 71, therefore the long sides 71a in the two sensor elements 5 are connected to each other.

In the integrally formed sensor elements 5, the directions of extension of the arms are for example parallel to each other. In other words, the orthogonal coordinate systems xyz attached to the sensor elements 5 coincide between the sensor elements 5. Further, in the example shown, in the integrally formed sensor elements 5, the lengths in the long direction (y-direction) (lengths of the long sides 71a) are made the same as each other. However, the two may be different from each other as well. The lengths in the short direction (x-direction) of the sensor elements 5 may be the same as each other or may be different from each other between the sensor elements 5.

In the example shown, the -x side element terminals 39 in the y-axis element 5Y and the +x side element terminals 39 in the x-axis element 5X do not overlap in position in the x-axis direction. Accordingly, it may be thought that the piezoelectric body 51 in the y-axis element 5Y and the piezoelectric body 151 in the x-axis element 5X have the long sides 71a in the frame portions 71 connected to each other. However, in the state where the -x side element terminals 39 in the y-axis element 5Y and the +x side element terminals 39 in the x-axis element 5X overlap in positions in the x-axis direction or otherwise the long sides 71a can be shared in part or as a whole, the piezoelectric body 51 and the piezoelectric body 151 may be integrally formed as well.

Between two or three sensor elements 5 having the piezoelectric bodies integrally formed, it is possible to share the element terminals 39. For example, it is clear that the element terminals 39 for the reference potential may be shared. Further, in a case where the frequencies of excitation are made the same as each other between the two or three sensor elements 5, it is also possible to share the element terminals 39 connected to the excitation electrodes 53.

At the time of judgment of whether the sensor elements 5 have the directions of extension of the arms as the long directions, the lengths of the sensor elements 5 in the directions of extension of the arms and the lengths of the sensor elements 5 in the directions perpendicular to the directions of extension of the arms must be identified. In turn, when the piezoelectric bodies are integrally formed, at the coupling portions, the boundaries between the sensor elements 5 must be identified. This may be reasonably judged based on the shapes and functions etc. of the sensor elements 5. As in the example shown, when the positions in the x-axis direction of the element terminals 39 do not overlap between two sensor elements 5, for example, the position at which the distances from the element terminals 39 in the two become equal to each other (intermediate position between the -x side element terminal 39 in the y-axis element 5Y and the +x side element terminal 39 in the x-axis element 5X) may be determined as the boundary of the two sensor elements 5. Further, in a case other than that described above, for example, the position at the center in the width of the connected long sides 71a may be determined as the boundary of the two sensor elements 5. This is because, when the piezoelectric bodies are connected to each other between the sensor elements 5, in an extreme case, it is also possible to provide the element terminal 39 in one sensor element 5 in the piezoelectric body in the other sensor element 5, therefore it is unreasonable to judge the sizes of the sensor elements 5 using the element terminals 39 as the standard.

### [Arrangement of Plurality of Sensor Elements]

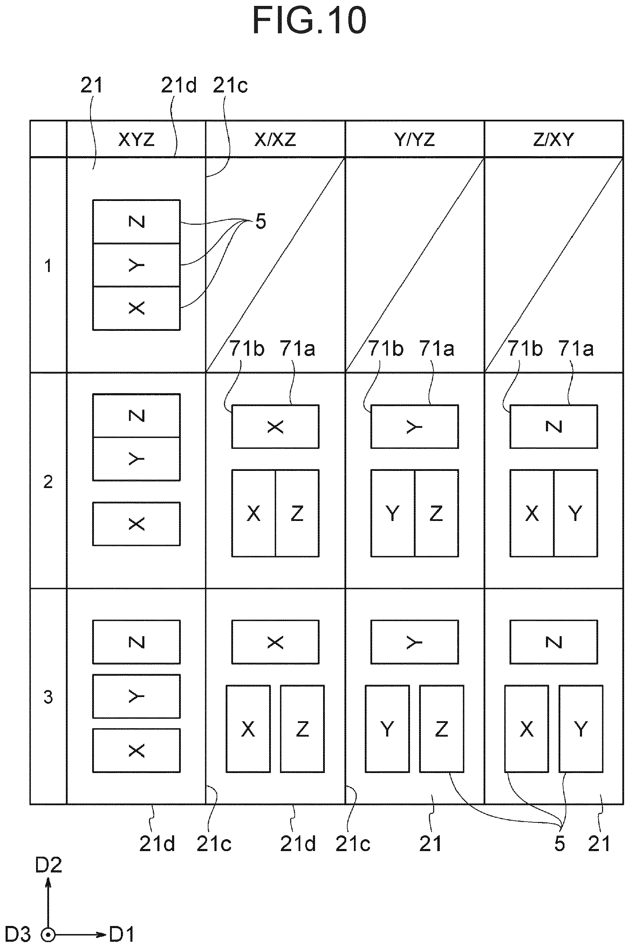

FIG. 10 is a view showing a table of examples of combination of the types and arrangements of three sensor elements 5 according to the embodiment.

In this view, 1 box in the table corresponds to the planar shape of a substrate part 21 (from another viewpoint, a package 1). Borderlines of the box correspond to the long sides 21c and short sides 21d configuring the outer edges of the substrate parts 21.

The rectangles in the boxes show the sensor elements 5. In the rectangles, X, Y, and Z show that the sensor elements 5 are the x-axis element 5X, y-axis element 5Y, or z-axis element 5Z. As will be understood form notations of the long sides 71a and short sides 71b, the long directions and short directions of the rectangles in the boxes correspond to the long directions and short directions of the sensor elements 5 (from another viewpoint, the directions of extension and direction of arrangement of the arms) . The rectangles contacting each other in the boxes, as explained with reference to FIG. 9, show that the sensor elements 5 are integrally formed with each other. Conversely, the rectangles which are separated from each other in the boxes show that the sensor elements 5 are not integrally formed with each other (are separated from each other).

In this table, nine modes of the types and arrangements of the three sensor elements 5 are shown. Among these nine modes, modes shown in the same columns have common features. Further, there are common features between the modes shown in the same row. In the following explanation, sometimes the columns will be referred to as the "XYZ" column, the "X/XZ" column, the "Y/YZ" column, and the "Z/XY" column using the letters shown in the uppermost boxes. Further, sometimes the rows will be referred to as the "1" row, the "2" row, and the "3" row using the numbers shown in the leftmost boxes.

### (Combination of Types of Sensor Elements)

As already explained, the sensor elements 5 are mounted in the substrate part 21 so that the z-axes in the orthogonal coordinate system xyz coincide with the D3 axis. Further, in all modes, detection of the angular velocity about the D3 axis is realized by provision of the z-axis element 5Z.

In the five modes shown in the "XYZ" column and "Z/XY" column, three types of sensor elements 5 mutually different in the axes in the orthogonal coordinate systems xyz about which the angular velocities are detected are combined. That is, in addition to the z-axis element 5Z, provision is made of the x-axis element 5X and y-axis element 5Y. Further, one of the x-axis element 5X and y-axis element 5Y is utilized for the detection of the angular velocity about the D1 axis, and the other of the x-axis element 5X and y-axis element 5Y is utilized for the detection of the angular velocity about the D2 axis.

In more detail, in the three modes shown in the "XYZ" column, the y-axis element 5Y is utilized for the detection of the angular velocity about the D1 axis, and the x-axis element 5X is utilized for the detection of the angular velocity about the D2 axis. Conversely, in the three modes shown in the "Z/XY" column, the x-axis element 5X is utilized for the detection of the angular velocity about the D1 axis, and the y-axis element 5Y is utilized for the detection of the angular velocity about the D2 axis.

In the four modes shown in the "X/XZ" column and the "Y/YZ" column, in addition to the z-axis element 5Z, two sensor elements 5 which are the same as each other in the axes (however, x-axes or y-axes) in the orthogonal coordinate systems xyz about which the angular velocities are detected are combined. That is, in addition to the z-axis element 5Z, two x-axis elements 5X or two y-axis elements 5Y are provided. The two sensor elements 5 of the same type are arranged with mutually different orientations in the D1D2 plane, whereby one is utilized for the detection of the angular velocity about the D1 axis, and the other is utilized for the detection of the angular velocity about the D2 axis.

In more detail, in the two modes shown in the "X/XZ" column, two x-axis elements 5X are utilized for the detection of the angular velocities about the D1 axis and about the D2 axis. In the two modes shown in the "Y/YZ" column, two y-axis elements 5Y are utilized for the detection of the angular velocities about the D1 axis and about the D2 axis.

### (Arrangements of Sensor Elements)

The shown nine modes, from the viewpoint of arrangement of the three sensor elements 5, can be grouped into the three modes shown in the "XYZ" column and the six modes shown in the other columns. In the following explanation, for convenience, two or more sensor elements 5 which are arranged so that their long sides 71a become parallel to each other will be sometimes simply expressed as "the sensor elements 5 which are parallel to each other" or the like. Further, two or more sensor elements 5 which are arranged so that their long sides 71a are perpendicular to each other will be sometimes simply expressed as "the sensor elements 5 which are perpendicular to each other" or the like.

In the three modes shown in the "XYZ" column, the three sensor elements 5 are arranged in one column. More specifically, the three sensor elements 5 are arranged side by side in the direction along the long sides 21c of the substrate part 21 (for example, may be made the direction substantially parallel to the long sides 21c) with orientations so that their long sides 71a (from another viewpoint, directions of extension of the arms) become parallel to the short sides 21d of the substrate part 21. From another viewpoint, the three sensor elements 5 are arranged so as to be parallel to each other.

In the six modes shown in the other columns, two among the three sensor elements 5 are arranged side by side in the direction along the short sides 21d of the substrate part 21 (for example, may be made the direction substantially parallel to the short sides 21d) with orientations so that their long sides 71a (from another viewpoint, directions of extension of the arms) become parallel to the long sides 21c of the substrate part 21. The remaining one sensor element 5 is arranged in the direction along the long sides 21c of the substrate part 21 (for example, may be made the direction substantially parallel to the long sides 21c) relative to the above two sensor elements 5 with an orientation so that its long sides 71a become parallel to the short sides 21d of the substrate part 21. From another viewpoint, the two sensor elements 5 are arranged so as to be parallel to each other, and the remaining one sensor element 5 is arranged so as to be perpendicular to the other two sensor elements 5.

In more detail, in the two modes in the "X/XZ" column, the x-axis element 5X and the z-axis element 5Z are parallel to each other. In the two modes in the "Y/YZ" column, the y-axis element 5Y and the z-axis element 5Z are parallel to each other. In the two modes in the "Z/XY" column, the x-axis element 5X and the y-axis element 5Y are parallel to each other.

In the example shown, one sensor element 5 is positioned on the +D2 side from the two sensor elements 5 which are parallel to each other. However, the positional relationship may be inverse as well.

The sequence of the two or more sensor elements 5 which are arranged parallel to each other is not limited to the example shown and may be suitably changed. For example, in the "XYZ" column, the sequence of X, Y, and Z is shown. However, this may be replaced by a sequence of X, Z, and Y, a sequence of Y, X, and Z, a sequence of Y, Z, and X, a sequence of Z, X, and Y, or a sequence of Z, Y, and X. The sequence of X and Z in the "X/XZ" column may be inverse to that in the example shown. The sequence of YZ in the "Y/YZ" column may be inverse to that in the example shown. The sequence of "Z/XY" may be inverse to the example shown. Further, in each sensor element 5, any of the +y side and -y side may be made one side in the long direction of each sensor element 5 shown in FIG. 10 (may be rotated by 180° about the axis parallel to the D3 axis).

### (Integral Formation of Sensor Elements)

In one mode shown in the "1" row, the three sensor elements 5 are integrally formed. From another viewpoint, if two or more integrally formed sensor elements 5 are regarded as one element, only one element is mounted in the substrate part 21.

In the four modes shown in the "2" row, among the three sensor elements 5, two are integrally formed and the remaining one is separate. From another viewpoint, if the two or more integrally formed sensor elements 5 are regarded as one element, two elements are mounted in the substrate part 21.

In more detail, concerning the "XYZ" column, the two mutually neighboring sensor elements 5 among the three are integrally formed. In the example shown, among the three sensor elements 5, the sensor element 5 at the center and the sensor element 5 at the +D2 side relative to the center one are integrally formed. However, conversely to the illustration, the sensor element 5 at the center and the sensor element 5 positioned on the -D2 side relative to this may be integrally formed as well. As already explained, the sequence of X, Y, and Z may be different from that in the example shown. In turn, the types of the sensor elements 5 which are integrally formed may be different from those in the example shown.

Further, concerning the "X/XZ", "Y/YZ", and "Z/XY" columns, the two sensor elements 5 which are arranged parallel to each other are integrally formed. As already explained, the sequence of these two sensor elements 5 may be inverse to that in the example shown as well.

In the four modes shown in the row "3", all of the three sensor elements 5 are separate. From another viewpoint, if two or more integrally formed sensor elements 5 are regarded as one element, three elements are mounted in the substrate part 21.

### (One Example of Dimensions of Region Where Sensor Elements are Arranged)

In the modes shown in the "XYZ" column, for example, when viewed in the D2 direction, the three sensor elements 5 are arranged so that the entireties of the ranges of arrangement (D1 direction) of two sensor elements 5 fall in the range of arrangement (D1 direction) of the sensor element 5 having the longest long sides 71a among the three (including a case where the former ranges coincide with the latter range). The lengths of the longest long sides 71a may be made for example, as already explained, 1.5 times or less or 1.1 times or less of the lengths of the shortest long sides 71a. Further, when comparing the shortest long sides 71a and the distances (D1 direction) between the long sides of the inner edge of the first frame portion 23 in the package 11, for example, the latter may be set to 1.6 times or less or 1.2 times or less of the former.

In the modes shown in the columns of "X/XZ", "Y/YZ", and "Z/XY", for example, when viewed in the D2 direction, the three sensor elements 5 are arranged so that the entirety of one of the ranges of arrangement (D1 direction) of two mutually parallel sensor elements 5 and the range of arrangement (D1 direction) of the sensor element 5 which is perpendicular to the two sensor elements 5 falls in the other (including a case where the one coincide with other) . The ranges of arrangement (D1 direction) of the two mutually parallel sensor elements 5 are ranges from the -D1 side outer edge of the -D1 side sensor element 5 up to the +D1 side outer edge of the +D1 side sensor element 5. Between the lengths in the D1 direction of the above two ranges of arrangement, the longer length may be made 1.7 times or less, 1.5 times or less, 1.3 times or less, 1.2 times or less, or 1.1 times or less of the shorter one. Further, when comparing the length in the D1 direction of the shorter range of arrangement and the distance (D1 direction) between the long sides of the inner edge of the first frame portion 23 in the package 11, for example, the latter may be made 1.8 times or less, 1.6 times or less, 1.4 times or less, 1.3 times or less, or 1.2 times or less of the former.

Further, in the modes shown in the columns of "X/XZ", "Y/YZ", and "Z/XY", the mutually parallel sensor elements 5 are arranged so that, when viewed in the D1 direction, the entirety of one of the ranges of arrangement (D2 direction) of the two sensor elements 5 (long sides 71a) falls in the other (including the case of coincidence) . At this time, the length of the longer long side 71a may be made 1.5 times or less or 1.1 times or less of the length of the shorter long side 71a.

### [One Example of Arrangement of Conductors in Substrate Part]

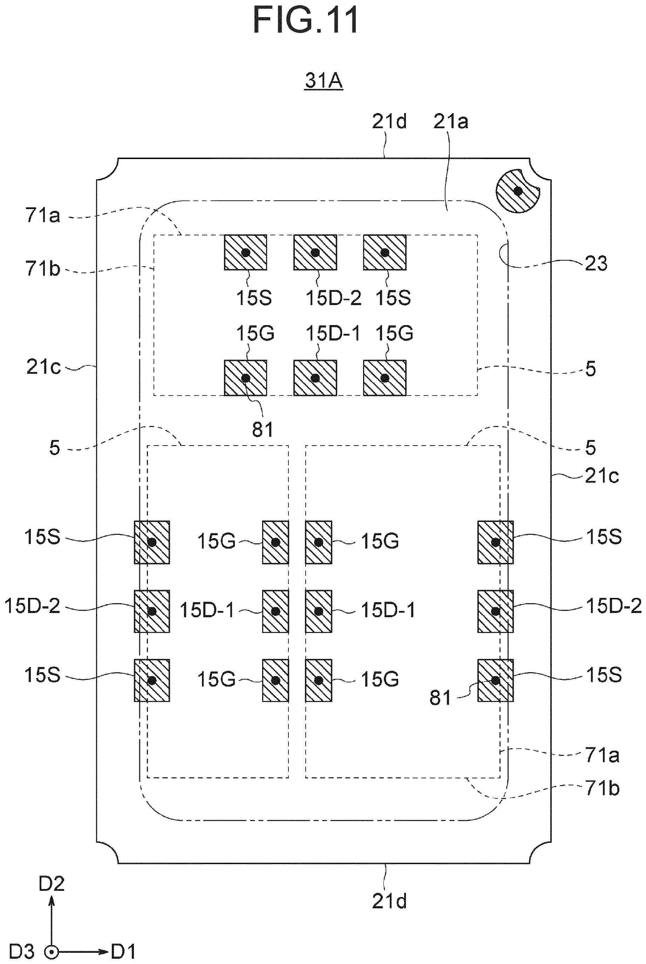

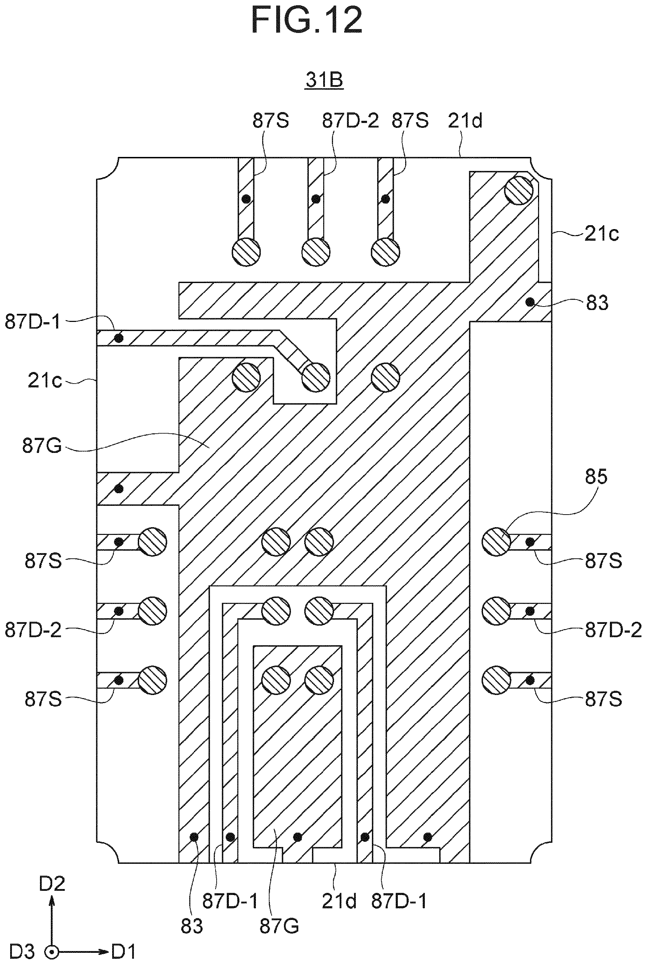

One example of arrangement of the conductors (element pads 15 etc.) in the substrate part 21 will be explained with reference to FIG. 11 and FIG. 12. Here, a case where the mode of arrangement of the three sensor elements 5 is any of the six modes shown in the "X/XZ", "Y/YZ", and "Z/XY" columns will be taken as an example.

FIG. 11 is a plan view showing the upper surface 21a of the substrate part 21 (first insulation layer 31A).

In this view, hatchings are applied to the surfaces of the conductor layers (that is, the surfaces which are not cross-sections) on the upper surface 21a. Further, via conductors 81 passing through the first insulation layer 31A are indicated by black circles. The outer edges of the sensor elements 5 are indicated by dotted lines. The inner edge of the first frame portion 23 in the package body 3 is indicated by a two-dot chain line.

In this view, the element pads 15 bonded with the element terminals 39 in the sensor elements 5 are given additional notations comprised of capital letters in accordance with their roles. The element pads 15D-1 and 15D-2 are for inputting driving signals to the excitation electrodes 53. However, the element pads 15D-2 may correspond to virtual grounds. Further, the element pads 15S are for extracting the detection signals from the detecting electrodes 55 or 255. The element pads 15G are for giving the reference potentials to the reference potential patterns 57.

As already explained, in each sensor element 5, the pair of long sides 71a in the frame portion 71 are provided with three each, that is, a total of six, element terminals 39. Corresponding to this, the package 11 has a total of six element pads 15 in total, that is, three each in two columns, with respect to each sensor element 5.

Two sensor elements 5 among the three are arranged so that the pairs of long sides 71a become parallel to the long sides 21c of the substrate part 21 as explained with reference to FIG. 10. Accordingly, among the six element pads 15 corresponding to each of these two sensor elements 5, three are positioned relatively on the long side 21c side and are arranged along the long side 21c and the remaining three are positioned on the inner side of the substrate part 21 (side of separation from the long side 21c) than the former. Between the three element pads 15 which are positioned relatively on the long side 21c side and the long sides 21c (or inner edge of the first frame portion 23), no other conductor is interposed, therefore the two can be grasped to be adjacent.

The remaining one sensor element 5 among the three, as explained with reference to FIG. 10, is arranged so that the pair of long sides 71a become parallel to the short sides 21d of the substrate part 21. Accordingly, among the six element pads 15 corresponding to this sensor element 5, three are positioned relatively on the short side 21d side of the substrate part 21 and are arranged along the short side 21d, and the remaining three are positioned on the inner side of the substrate part 21 (side away from the short side 21d) from the former. Between the three element pads 15 which are positioned relatively on the short side 21d side and the short sides 21d (or inner edge of the first frame portion 23), no other conductor is interposed, therefore the two can be grasped to be adjacent.

When summarizing this, the package 11, with respect to each of the three sensor elements 5, has a plurality of element pads 15 which are arranged along the outer edge of the substrate part 21 and a plurality of element pads 15 which are positioned on the inner side of the substrate part 21 from the former.

Further, in the example shown, for all sensor elements 5, the detection-use element pads 15S are positioned on the outer edge side of the substrate part 21. In more detail, for example, in each sensor element 5, among the three element pads 15 which are arranged along the outer edge of the substrate part 21, the two element pads 15 on the two sides are used for detection. Between these two element pads 15S, the element pad 15D-2 corresponding to the virtual ground is positioned. Other than the example shown, for example, in place of the element pad 15D-2, the reference potential-use element pad 15G may be positioned as well.

Further, in the example shown, for all sensor elements 5, the reference potential-use element pads 15G are positioned on the inner side of the substrate part 21. In more detail, for example, among the three element pads 15 arranged on the inner side of the substrate part 21, the two element pads 15 on the two sides are used for the reference potential. Between these two element pads 15G, the driving signal-use element pad 15D-1 is positioned. Other than the example shown, for example, the two element pads 15 on the two sides among the three element pads 15 on the inner side of the substrate part 21 may be made the driving-use element pads 15D-1 and 15D-2 and one between them may be made the reference potential-use as well.

The conductor layer (notation is omitted) and via conductor 81 which are positioned in the +D1 side and +D2 side corner portion of the substrate part 21 are for giving the reference potential to the lid body 9. Such conductors need not be provided either.

FIG. 12 is a plan view showing the internal portion of the substrate part 21 (upper surface of the second insulation layer 31B) .

This view is predicated on the example in FIG. 11. In this view, in the same way as FIG. 11, hatchings are applied to the surfaces of the conductor layers (that is, surfaces which are not cross-sections) on the upper surface of the second insulation layer 31B. Further, among these conductor layers, connection regions 85 which are connected with the via conductors 81 passing through the first insulation layer 31A are given hatchings different from those of the other regions. Further, in this view, the via conductors 83 passing through the second insulation layer 31B are indicated by black circles.

The conductor layers positioned on the upper surface of the second insulation layer 31B for example have driving wirings 87D-1 and 87D-2, detection wirings 87S, and reference potential patterns 87G. These wirings and patterns include the connection regions 85 which are connected to the plurality of element pads 15. However, the connection regions 85 may be grasped as different portions from the wirings and patterns as well.

The plurality of connection regions 85 are for example positioned just under the plurality of element pads 15 and are connected with the element pads 15 by the via conductors 81 (FIG. 11). Accordingly, the explanation of the element pads 15 may be cited for the connection regions 85 with respect to the relationships between the roles and the positions of arrangement in a plane perspective. In the connection region 85, a portion on the surface side or the entirety in the thickness direction may be configured by a material different from the materials of the other regions in the conductor layers on the upper surface of the second insulation layer 31B.

The driving wirings 87D-1 are connected with the element pads 15D-1 in the connection regions 85. The driving wirings 87D-2 are connected with the element pads 15D-2 in the connection regions 85. The detection wirings 87S are connected with the element pads 15S in the connection regions 85.

These wirings substantially extend from the connection regions 85 toward the outer edge of the substrate part 21. In particular, the wirings which are connected with the element pads 15 (15S and 15D-2) arranged along the outer edge of the substrate part 21 do not include portions extending to directions away from the outer edge of the substrate part 21. These wirings include only portions which extend toward the outer edge of the substrate part 21 or include only portions parallel with respect to the outer edge in addition to the former portions. When referring to as "extend toward the outer edge of the substrate part 21", they may extend to not only directions perpendicular to the outer edge, but also to directions inclined relative to the outer edge.

The reference potential patterns 87G are connected with the element pads 15G. The reference potential patterns 87G, for example, are provided on the upper surface of the second insulation layer 31B over the majority of the area excluding the positions of the wirings described above. For example, the area of the reference potential patterns 87G may be made 50% or more of the area of the second insulation layer 31B.

Further, the reference potential patterns 87G are positioned among various types of wirings explained above. For example, for each sensor element 5, the reference potential pattern 87G is positioned between the three wirings of the two detection wirings 87S and driving wiring 87D-2 and the driving wiring 87D-1. As shown concerning the pair of detection wirings 87S and the driving wiring 87D-2 which are adjacent to the long side 21c, the reference potential pattern 87G may reach the outer edge of the substrate part 21 and completely separate the above three wirings and the driving wiring 87D-1 on the upper surface of the second insulation layer 31B.

The various types of wirings explained above, for example, are connected with the via conductors 83 midway of the extensions and in the vicinity of the outer edge of the substrate part 21. Further, the reference potential pattern 87G, for example, is connected with the via conductors 83 in the vicinity of the outer edge of the substrate part 21. The via conductors 83, for example, are electrically connected with the IC pads 17 through not shown conductor layers provided lower than the upper surface of the second insulation layer 31B in the substrate part 21.

As explained above, in the present embodiment, the multi-axial angular velocity sensor 1 has the package 11 and three sensor elements 5 (first axial element, second axial element, and third axial element). The package 11 has the substrate part 21. The substrate part 21 has the first surface (upper surface 21a) perpendicular to the D3 axis among the mutually perpendicular first axis (D1 axis), second axis (D2 axis), and third axis (D3 axis). The outer edge of the upper surface 21a has the pair of long sides 21c parallel to the D2 axis and the pair of short sides 21d parallel to the D1 axis. The three sensor elements 5 are mounted on the upper surface 21a and respectively detect the angular velocities about the D1 axis, about the D2 axis, and about the D3 axis. The three sensor elements 5 respectively have the piezoelectric body 51 or 151, excitation electrodes 53, and detecting electrodes 55 or 255. The piezoelectric body 51 or 151 has pluralities of arms (driving arms 63 or 163 and detecting arms 65 or 165). These arms extend in predetermined directions of extension (regardless of positive/negative directions) in a plane perspective of the upper surface 21a. The piezoelectric body 51 or 151 has the directions of extension of the pluralities of arms as the long direction. The excitation electrodes 53 are positioned in portions of the plurality of arms (driving arms 63 or 163) . The detecting electrodes 55 or 255 are positioned in the other portions of the plurality of arms (detecting arms 65 or 165) . The two sensor elements 5 among the three are arranged side by side in the direction along the short sides 21d of the substrate part 21 with orientations so that the directions of extension of the arms become parallel to the long sides 21c of the substrate part 21. The remaining one is arranged in the direction along the long sides 21c relative to the above two elements with an orientation so that the directions of extension of the arms become parallel to the short sides 21d. Otherwise, the three sensor elements 5 are arranged side by side in the direction along the long sides 21c of the substrate part 21 with orientations so that the directions of extension of the arms become parallel to the short sides 21d of the substrate part 21.

In this case, for example, the probability of the region where the three sensor elements 5 are arranged becoming extremely elongated can be lowered. In turn, the probability of the package 11 becoming elongated when viewed on a plane can be lowered. As a result, for example, the strength of the package 11 against a force making the package 11 flex can be increased and the probability of formation of dead space when mounting the sensor 1 on a circuit board can be lowered. From another viewpoint, when a package 11 which is a rectangular shape close to a square is prepared, the probability of formation of dead space in the package 11 can be lowered.

Further, in the present embodiment, in each of the three sensor elements 5, the piezoelectric body 51 or 151 has the frame portion 71. The frame portion 71 surrounds the pluralities of arms (driving arms 63 etc.) in a plane perspective of the upper surface 21a of the substrate part 21. Further, the frame portion 71 is a rectangle having the directions of extension of the arms as the long direction.

In this case, for example, positioning of the sensor elements 5 and the substrate part 21 when viewed on a plane is facilitated. More specifically, for example, the positioning is carried out by using a visual sensor (including an imager). Due to provision of the frame portion 71, the position of the sensor element 5 can be correctly detected. As a result, the parallelism of the various types of arms relative to the long sides 21c or short sides 21d of the substrate part 21 can be improved. Due to improvement of the parallelism, for example, the influence of the angular velocity about the D2 axis or about the D3 axis exerted upon the detection signals of the sensor element 5 detecting the angular velocity about the D1 axis is reduced. The same is true for the other axes.

Further, in the present embodiment, the two sensor elements 5 among the three may be arranged side by side in the direction along the short sides 21d of the substrate part 21 with orientations so that the directions of extension of the arms become parallel to the long sides 21c of the substrate part 21. The remaining one may be arranged in the direction along the long sides 21c of the substrate part 21 relative to the above two sensor elements 5 with an orientation so that the directions of extension of the arms become parallel to the short sides 21d of the substrate part 21.

In this case, for example, the vibration directions of the driving arms 63 and/or 263 may be made different from each other among the sensor elements 5. As a result, the mutual influences of the sensor elements 5 are reduced. Further, one of the two sensor elements 5 and the remaining one sensor element 5 can be made sensor elements 5 of the same type. Due to this, for example, the development load is lightened or the productivity is improved and the like and thus the costs can be reduced.

The piezoelectric body 51 and/or 151 in the three sensor elements 5 may be separated from each other.

For example, in a mode where the three sensor elements 5 are integrally formed, when one of the three sensor elements 5 is judged as a defective product in the inspection before the sensor elements 5 are mounted in the substrate part 21, the other two sensor elements 5 are also discarded. On the other hand, in a mode where the three sensor elements 5 are separated from each other, such an inconvenience does not occur. Further, for example, at the present point of time, sensor elements 5 which are not integrally formed are the main types, therefore conventional sensor elements 5 are easily utilized.

However, among the three sensor elements 5, the piezoelectric bodies 51 and/or 251 in at least two sensor elements 5 in which the directions of extension of the arms are parallel to each other may be integrally formed as well.

In this case, for example, clearance is unnecessary between the sensor elements 5, therefore this is useful for reduction of the size. Further, for example, as already referred to, it is also possible to share the element terminals 39.

Further, in the example shown in FIG. 11 and FIG. 12, the package 11 has, for each of the three sensor elements 5, the pairs of driving pads (element pads 15D-1 and 15D-2) and the pair of detection pads (element pads 15S) on the upper surface 21a of the substrate part 21. The element pads 15D-1 and 15D-2 are electrically connected with the plurality of excitation electrodes 53. The pair of element pads 15S are electrically connected with the plurality of detecting electrodes 55 or 255. Between the two sensor elements 5 which are arranged side by side in the direction along the short sides 21d of the substrate part 21, at the sensor element 5 positioned on one long side 21c side, the pair of element pads 15S are positioned on the side closer to the one long side 21c than at least one driving pad (element pad 15D-1) and are arranged along the one long side 21c. Also at the sensor element 5 on the other long side 21c side, the same stands relative to the other long side 21c. Further, at the remaining one element positioned on one short side 21d side of the substrate part 21 relative to these two sensor elements 5, the pair of element pads 15S are positioned on the side closer to the one short side 21d than at least one driving pad (element pad 15D-1) and are arranged along the one short side 21d.

That is, among the three sensor elements 5, the detection-use element pads 15S are arranged on the outer edge side in the substrate part 21 to be separated as much as possible. Due to this, influences of the detection signals exerted upon each other among the sensor elements 5 are reduced, and the detection accuracy can be improved. From another viewpoint, a higher priority is given to reduction of noise which is mixed into the detection signals than the reduction of noise mixed into the driving signals. Due to this, the detection accuracy is improved. Such an arrangement is easily realized in a configuration where the two sensor elements 5 are arranged parallel to each other and the remaining one sensor element 5 is made perpendicular with respect to the above two sensor elements 5.

In the mode described above, the package 11 may have a conductor layer parallel to the upper surface 21a of the substrate part 21 inside the substrate part 21. This conductor layer, with respect to each of the three sensor elements 5, has driving wirings 87D-1 and 87D-2, a pair of detection wirings 87S, and a reference potential pattern 87G. The driving wirings 87D-1 and 87D-2 are electrically connected to the element pads 15D-1 and 15D-2. The pair of detection wirings 87S are electrically connected to the pair of element pads 15S. The reference potential pattern 87G
according to the invention is positioned between at least the driving wiring 87D-1 and the pair of detection wirings 87S in each of the three sensor elements 5.

In this case, for example, isolation between the driving wiring 87D-1 and the detection wiring 87S is improved, whereby the detection accuracy can be improved.

Further, in the mode described above, the pair of detection wirings 87S are electrically connected to the pair of element pads 15S at positions right under the pair of element pads 15S and extend from the positions right under the pair of element pads 15S toward the outer edge of the substrate part 21.

In this case, for example, it is easy to position the reference potential pattern 87G on the inner side of the substrate part 21 relative to the detection wirings 87S. In turn, it is easy to position the reference potential pattern 87G between the driving wiring 87D-1 and the detection wiring 87S.

Further, in the present embodiment, the sensor 1 further has the IC 7. The IC 7 is mounted on the lower surface 21b of the back face of the upper surface 21a of the substrate part 21 and is electrically connected with the three sensor elements 5.

Accordingly, for example, compared with a mode where the sensor elements 5 and the IC 7 are arranged on the same plane (this mode may also be included in the technique according to the present disclosure), the sensor 1 can be reduced in size. Further, compared with a mode where they are arranged on the same plane, the influence of heat generated by the IC 7 exerted upon the sensor elements 5 is equalized. As a result, for example, temperature compensation is facilitated.

In the above embodiment, the upper surface 21a of the substrate part 21 is one example of the first surface. The lower surface 21b of the substrate part 21 is one example of the second surface. The D1 axis, D2 axis, and D3 axis are examples of the first axis, second axis, and third axis. The three sensor elements 5 in the sensor 1 are examples of the first axial element, second axial element, and third axial element. As understood from the explanation with reference to FIG. 10, these are realized by any of the x-axis element 5X, y-axis element 5Y, and z-axis element 5Z. The element pads 15D-1 and 15D-2 are examples of the pair of driving pads. The element pad 15S is one example of the detection pad. The IC 7 is one example of the integrated circuit element.

The present invention is not limited to the above embodiment and may be executed in various modes.

As mentioned in the beginning of the explanation of the embodiment, the multi-axial angular velocity sensor need not have a driving circuit and detecting circuit. That is, the multi-axial angular velocity sensor may be one making the sensor element vibrate by a driving signal input from an external portion and outputting the detection signals generated in the sensor element to the external portion as they are.

The sensor element or multi-axial angular velocity sensor may be configured as a portion of an MEMS (micro electro mechanical system) . In this case, a piezoelectric body configuring the sensor element may be mounted on the substrate of MEMS, or the substrate of MEMS may be configured by a piezoelectric body and a portion of that may configure the piezoelectric body of the sensor element.

The basic configurations relating to detection of the angular velocity of the sensor element (for example numbers, directions of extension, arrangements and vibration directions of driving arms and detecting arms) are not limited to those illustrated in the embodiment. For example, as another representative example, a tuning fork type can be mentioned. Further, for example, as in Japanese Patent Publication No. 2015-099130, the driving arms which are arranged line symmetrically about the symmetrical axis parallel to the y-axis may flex to the same sides in the x-direction as well. Further, as disclosed in the above publication and Japanese Patent Publication No. 2015-141182, in a configuration where the driving arm and the detecting arm extend alongside each other, the angular velocity about the y-axis may be detected as well.

The piezoelectric body need not have a frame portion either. For example, the piezoelectric body may be mounted by provision of the element terminals in the base part. Further, for example, the piezoelectric body may be mounted in a manner where a mounting arm which extends from the base part alongside the driving arm and detecting arm is provided, and the element terminals are provided on the mounting arm.

The piezoelectric body 151 in the embodiment had the inner side frame portion 169 and frame portion 71. However, the projection portion 170 and frame portion 71 may be omitted, and the element terminals 39 may be provided in the inner side frame portion 169. Conversely, a combination of the inner side frame portion and its outer side frame portion may be provided in the piezoelectric body 51 as well.

Further, in the piezoelectric body 51, the base part 61 was held at one point by one holding portion 69 extending alongside the detecting arms. However, the base part 61 may be supported at two points by two holding portions 69 which extend from the base part 61 to inverse sides to each other, may be held at one point by the holding portion 69 extending alongside the driving arms, or may be supported by connection at the two ends in the x-direction of the base part 61 with the pair of long sides 71a of the frame portion 71 without providing the holding portion 69.

The package is not limited to one having a package body having recessed portions formed in the upper and lower parts. For example, the package may be one having a package body having a recessed portion formed only in the upper part as well. Further, for example, the package may be one in a mode where a package body having a recessed portion formed therein is not provided, and a box type cap is placed on the upper surface of the substrate part.

### Reference Signs List

1... multi-axial angular velocity sensor, 3... package body, 5... sensor element, 11... package, 21... substrate part, 21a... upper surface (first surface) of substrate part, 21c... long side of substrate part, 21d... short side of substrate part, 51... piezoelectric body, 53... excitation electrode, 55... detecting electrode, 63... driving arm, 65... detecting arm, 151... piezoelectric body, 163... driving arm, 165... detecting arm, and 255... detecting electrode.

## Claims

1. A multi-axial angular velocity sensor (1) comprising:
a package (11) comprising a substrate part (21), the substrate part (21) comprising a first surface (21a) perpendicular to a third axis (D3) among a first axis (D1), second axis (D2), and the third axis (D3) which are perpendicular to each other, an outer edge of the first surface (21a) comprising a pair of long sides (21c) parallel to the second axis (D2) and a pair of short sides (21d) parallel to the first axis (D1);
a first axial element (5X) which is mounted on the first surface (21a) and is configured to detect an angular velocity about the first axis (D1) ;
a second axial element (5Y) which is mounted on the first surface (21a) and is configured to detect the angular velocity about the second axis (D2); and
a third axial element (5Z) which is mounted on the first surface (21a) and is configured to detect the angular velocity about the third axis (D3) ;
wherein each of the first axial element (5X), the second axial element (5Y), and the third axial element (5Z) comprises:
a piezoelectric body (51) comprising a plurality of arms (63, 65) extending in a predetermined direction of extension in a plan perspective of the first surface (21a) and having the predetermined direction of extension as a long direction of the piezoelectric body (51),
an excitation electrode (53A, 53B) on a portion of the plurality of arms (63), and
a detecting electrode (55) on another portion of the plurality of arms (65);
wherein two axial elements of the first axial element (5X), the second axial element (5Y), and the third axial element (5Z) are arranged side by side in a direction along the pair of short sides (21d) with orientations so that the direction of extension of each of the two axial elements are parallel to the pair of long sides (21c), and a remaining one axial element of the first axial element (5X), the second axial element (5Y), and the third axial element (5Z) is arranged in a direction along the pair of long sides (21c) relative to the two axial elements with an orientation so that the direction of extension is parallel to the pair of short sides (21d), or
three axial elements of the first axial element (5X), the second axial element (5Y), and the third axial element (5Z) are arranged side by side in directions along the pair of long sides (21c) with orientations so that the directions of extension become parallel to the pair of short sides (21d); and
**characterized in that**
the substrate part (21) comprises a reference potential pattern (87G) which is shared by the first axial element (5X), the second axial element (5Y), and the third axial element (5Z) .

2. The multi-axial angular velocity sensor (1) according to claim 1, wherein
in each of the first axial element (5X), the second axial element (5Y), and the third axial element (5Z),
the piezoelectric body (51) comprises a frame portion (71) surrounding the plurality of arms (63, 65) in the plan perspective of the first surface (21a), and
the frame portion (71) is rectangular shaped having the predetermined direction of extension as the long direction.

3. The multi-axial angular velocity sensor (1) according to claim 1 or 2, wherein the multi-axial angular velocity sensor (1) comprises the two axial elements of the first axial element (5X), the second axial element (5Y), and the third axial element (5Z) arranged side by side in a direction along the pair of short sides (21d) with the orientations so that the direction of extension of the each of the two axial elements are parallel to the pair of long sides (21c), and the remaining one axial element of the first axial element (5X), the second axial element (5Y), and the third axial element (5Z) is arranged in the direction along the pair of long sides (21c) relative to the two axial elements with the orientation so that the direction of extension is parallel to the pair of short sides (21d).

4. The multi-axial angular velocity sensor (1) according to claim 3, wherein one of the two axial elements and the remaining one axial element is configured to detect angular velocities about axes parallel to the direction of extension or angular velocities about axes perpendicular to the direction of extension.

5. The multi-axial angular velocity sensor (1) according to any one of claims 1 to 4, wherein the piezoelectric bodies (51) in the first axial element (5X), the second axial element (5Y), and the third axial element (5Z) are separated from each other.

6. The multi-axial angular velocity sensor (1) according to any one of claims 1 to 4, wherein the piezoelectric bodies (51) in at least the two axial elements of the first axial element (5X), the second axial element (5Y), and the third axial element (5Z), in which the direction of extension are parallel to each other, are integrally formed.

7. The multi-axial angular velocity sensor (1) according to claim 3 or 4, wherein
with respect to each of the first axial element (5X), the second axial element (5Y), and the third axial element (5Z), the package (11) comprises, on the first surface,
a pair of driving pads (15D-1, 15D-2) which are electrically connected with a plurality of excitation electrodes (53A, 53B), and
a pair of detection pads (15S) which are electrically connected with a plurality of detecting electrodes (55),
at one element of the two axial elements arranged side by side in the direction along the pair of short sides (21d), which is located on a side closer to one of the pair of long sides (21c), the pair of detection pads (15S) are located on a side closer to the one of the pair of long sides (21c) than at least one of the pair of driving pads (15D-1, 15D-2), and are arranged along the one of the pair of long sides (21c),
at another element of the two axial elements arranged side by side in the direction along the pair of short sides (21d), which is located on a side closer to another of the pair of long sides (21c), the pair of detection pads (15S) are located on a side closer to the other of the pair of long sides (21c) than at least one of the pair of driving pads (15D-1, 15D-2), and are arranged along the other of the pair of long sides (21c), and
at the remaining one axial element located on a side closer to one of the pair of short sides (21d) relative to the two axial elements, the pair of detection pads (15S) are located on a side closer to the one of the pair of short sides (21d) than at least one of the pair of driving pads (15D-1, 15D-2), and are arranged along the one of the pair of short sides (21d).

8. The multi-axial angular velocity sensor (1) according to claim 7, wherein
the package (11) comprises a conductor layer parallel to the first surface (21a) in an internal portion of the substrate part (21),
the conductor layer comprises, with respect to each of the first axial element (5X), the second axial element (5Y), and the third axial element (5Z),
a pair of driving wirings (87D-1, 87D-2) which are electrically connected to the pair of driving pads (15D-1, 15D-2) and
a pair of detection wirings (87S) which are electrically connected to the pair of detection pads (15S), and
the conductor layer further comprises the reference potential pattern (87G) located between a driving wiring of the pair of driving wirings (87D-1, 87D-2) which is connected to the at least one of the pair of driving pads (15D-1, 15D-2) and the pair of detection wirings (87S) in each of the first axial element (5X), the second axial element (5Y), and the third axial element (5Z) .

9. The multi-axial angular velocity sensor (1) according to claim 8, wherein the pair of detection wirings (87S) are electrically connected to the pair of detection pads (15S) at positions immediately below the pair of detection pads (15S) and extend from the immediately below positions toward an outer edge of the substrate part (21).

10. The multi-axial angular velocity sensor (1) according to any one of claims 1 to 9, further comprising an integrated circuit element (7) which is mounted on a second surface (21b) of the substrate part (21) that is opposite to the first surface (21a), and is electrically connected with the first axial element (5X), the second axial element (5Y), and the third axial element (5Z).

## Patentansprüche

1. Mehrachsiger Winkelgeschwindigkeitssensor (1), umfassend:
ein Gehäuse (11) mit einem Substratteil (21), wobei das Substratteil (21) eine erste Oberfläche (21a) rechtwinklig zu einer dritten Achse (D3) unter einer ersten Achse (D1), einer zweiten Achse (D2) und der dritten Achse (D3), die rechtwinklig zueinander sind, umfasst, wobei ein Außenrand der ersten Oberfläche (21a) ein Paar langer Seiten (21c) parallel zu der zweiten Achse (D2) und ein Paar kurzer Seiten (21d) parallel zu der ersten Achse (D1) umfasst;
ein erstes axiales Element (5X), das auf der ersten Oberfläche (21a) angebracht ist und dazu ausgelegt ist, eine Winkelgeschwindigkeit um die erste Achse (D1) zu erfassen;
ein zweites axiales Element (5Y), das auf der ersten Oberfläche (21a) angebracht ist und dazu ausgelegt ist, die Winkelgeschwindigkeit um die zweite Achse (D2) zu erfassen; und
ein drittes axiales Element (5Z), das auf der ersten Oberfläche (21a) angebracht ist und dazu ausgelegt ist, die Winkelgeschwindigkeit um die dritte Achse (D3) zu erfassen;
wobei jedes des ersten axialen Elements (5X), des zweiten axialen Elements (5Y) und des dritten axialen Elements (5Z) Folgendes umfasst:
einen piezoelektrischen Körper (51), der eine Vielzahl von Armen (63, 65) umfasst, die sich in einer Draufsicht auf die erste Oberfläche (21a) in einer vorbestimmten Erstreckungsrichtung erstrecken und die vorbestimmte Erstreckungsrichtung als eine Längsrichtung des piezoelektrischen Körpers (51) aufweisen,
eine Erregungselektrode (53A, 53B) auf einem Abschnitt der Vielzahl von Armen (63), und
eine Erfassungselektrode (55) auf einem anderen Abschnitt der Vielzahl von Armen (65);
wobei zwei axiale Elemente des ersten axialen Elements (5X), des zweiten axialen Elements (5Y) und des dritten axialen Elements (5Z) nebeneinander in einer Richtung entlang des Paars kurzer Seiten (21d) so ausgerichtet angeordnet sind, dass die Erstreckungsrichtung jedes der zwei axialen Elemente parallel zu dem Paar langer Seiten (21c) verläuft, und ein verbleibendes axiales Element des ersten axialen Elements (5X), des zweiten axialen Elements (5Y) und des dritten axialen Elements (5Z) in einer Richtung entlang des Paars langer Seiten (21c) relativ zu den zwei axialen Elementen so ausgerichtet angeordnet ist, dass die Erstreckungsrichtung parallel zu dem Paar kurzer Seiten (21d) verläuft, oder
drei axiale Elemente des ersten axialen Elements (5X), des zweiten axialen Elements (5Y) und des dritten axialen Elements (5Z) nebeneinander in Richtungen entlang des Paars langer Seiten (21c) so ausgerichtet angeordnet sind, dass die Erstreckungsrichtungen parallel zu dem Paar kurzer Seiten (21d) werden; und
**dadurch gekennzeichnet, dass**
das Substratteil (21) ein Bezugspotentialmuster (87G) umfasst, das durch das erste axiale Element (5X), das zweite axiale Element (5Y) und das dritte axiale Element (5Z) gemeinsam genutzt wird.

2. Mehrachsiger Winkelgeschwindigkeitssensor (1) gemäß Anspruch 1, wobei
in jedem des ersten axialen Elements (5X), des zweiten axialen Elements (5Y) und des dritten axialen Elements (5Z)
der piezoelektrische Körper (51) einen Rahmenabschnitt (71) umfasst, der in der Draufsicht auf die erste Oberfläche (21a) die Vielzahl von Armen (63, 65) umgibt, und
der Rahmenabschnitt (71) rechteckig geformt ist und die vorbestimmte Erstreckungsrichtung als Längsrichtung aufweist.

3. Mehrachsiger Winkelgeschwindigkeitssensor (1) gemäß Anspruch 1 oder 2, wobei der mehrachsige Winkelgeschwindigkeitssensor (1) die zwei axialen Elemente des ersten axialen Elements (5X), des zweiten axialen Elements (5Y) und des dritten axialen Elements (5Z) nebeneinander in einer Richtung entlang des Paars kurzer Seiten (21d) so ausgerichtet umfasst, dass die Erstreckungsrichtung jedes der zwei axialen Elemente parallel zu dem Paar langer Seiten (21c) verläuft, und das verbleibende axiale Element des ersten axialen Elements (5X), des zweiten axialen Elements (5Y) und des dritten axialen Elements (5Z) in Richtung entlang des Paars langer Seiten (21c) relativ zu den zwei axialen Elementen so ausgerichtet angeordnet ist, dass die Erstreckungsrichtung parallel zu dem Paar kurzer Seiten (21d) verläuft.

4. Mehrachsiger Winkelgeschwindigkeitssensor (1) gemäß Anspruch 3, wobei eines der zwei axialen Elemente und des verbleibenden einen axialen Elements dazu ausgelegt ist, Winkelgeschwindigkeiten um Achsen parallel zur Ausdehnungsrichtung oder Winkelgeschwindigkeiten um Achsen rechtwinklig zur Ausdehnungsrichtung zu erfassen.

5. Mehrachsiger Winkelgeschwindigkeitssensor (1) gemäß einem der Ansprüche 1 bis 4, wobei der piezoelektrische Körper (51) in dem ersten axialen Element (5X), dem zweiten axialen Element (5Y) und dem dritten axialen Element (5Z) voneinander getrennt sind.

6. Mehrachsiger Winkelgeschwindigkeitssensor (1) gemäß einem der Ansprüche 1 bis 4, wobei der piezoelektrische Körper (51) in mindestens den zwei axialen Elementen des ersten axialen Elements (5X), des zweiten axialen Elements (5Y) und des dritten axialen Elements (5Z), in denen die Erstreckungsrichtungen parallel zueinander verlaufen, einstückig ausgebildet sind.

7. Mehrachsiger Winkelgeschwindigkeitssensor (1) gemäß Anspruch 3 oder 4, wobei
das Gehäuse (11) in Bezug auf das erste axiale Element (5X), das zweite axiale Element (5Y) und das dritte axiale Element (5Z) auf der ersten Oberfläche Folgendes umfasst:
ein Paar von Ansteuerungsplättchen (15D-1, 15D-2), die elektrisch mit einer Vielzahl von Erregungselektroden (53A, 53B) verbunden sind, und
ein Paar von Erfassungsplättchen (15S), die elektrisch mit einer Vielzahl von Erfassungselektroden (55) verbunden sind,
bei einem Element der zwei axialen Elemente, die nebeneinander in Richtung entlang des Paars kurzer Seiten (21d) angeordnet sind, das sich auf einer Seite befindet, die näher an einer des Paars langer Seiten (21c) liegt, das Paar von Erfassungsplättchen (15S) sich auf einer Seite befindet, die näher an einer des Paars langer Seiten (21c) als mindestens eines des Paars von Ansteuerplättchen (15D-1, 15D-2) liegt, und entlang der einen des Paars langer Seiten (21c) angeordnet ist,
bei einem anderen Element der zwei axialen Elemente, die nebeneinander in Richtung entlang des Paars kurzer Seiten (21d) angeordnet sind, das sich auf einer Seite befindet, die näher an einer anderen des Paars langer Seiten (21c) liegt, das Paar von Erfassungsplättchen (15S) sich auf einer Seite befindet, die näher an der anderen des Paars langer Seiten (21c) als mindestens eines des Paars von Ansteuerplättchen (15D-1, 15D-2) liegt, und entlang der anderen des Paars langer Seiten (21c) angeordnet ist, und
an dem verbleibenden einen axialen Element, das sich auf einer Seite befindet, die näher an einer des Paars kurzer Seiten (21d) relativ zu den zwei axialen Elementen liegt, das Paar von Erfassungsplättchen (15S) sich auf einer Seite befindet, die näher an der einen des Paars kurzer Seiten (21d) als mindestens eines des Paars von Ansteuerplättchen (15D-1, 15D-2) liegt, und entlang der einen des Paars kurzer Seiten (21d) angeordnet ist.

8. Mehrachsiger Winkelgeschwindigkeitssensor (1) gemäß Anspruch 7, wobei
das Gehäuse (11) eine zu der ersten Oberfläche (21a) parallele Leiterschicht in einem inneren Abschnitt des Substratteils (21) umfasst,
die Leiterschicht in Bezug auf jedes des ersten axialen Elements (5X), des zweiten axialen Elements (5Y) und des dritten axialen Elements (5Z) Folgendes umfasst:
ein Paar von Ansteuerungsleitungen (87D-1, 87D-2), die elektrisch mit dem Paar von Ansteuerungsplättchen (15D-1, 15D-2) verbunden sind, und
ein Paar von Erfassungsleitungen (87S), die elektrisch mit dem Paar von Erfassungsplättchen (15S) verbunden sind, und
die Leiterschicht ferner das Bezugspotentialmuster (87G) umfasst, das sich zwischen einer Ansteuerungsleitung des Paars von Ansteuerungsleitungen (87D-1, 87D-2) befindet, die mit dem mindestens einen des Paars von Ansteuerungsplättchen (15D-1, 15D-2) und dem Paar von Erfassungsleitungen (87S) in jedem des ersten axialen Elements (5X), des zweiten axialen Elements (5Y) und des dritten axialen Elements (5Z) verbunden ist.

9. Mehrachsiger Winkelgeschwindigkeitssensor (1) gemäß Anspruch 8, wobei das Paar von Erfassungsleitungen (87S) elektrisch mit dem Paar von Erfassungsplättchen (15S) an Positionen unmittelbar unter dem Paar von Erfassungsplättchen (15S) verbunden ist und sich von den unmittelbar darunter liegenden Positionen zu einer Außenkante des Substratteils (21) erstreckt.

10. Mehrachsiger Winkelgeschwindigkeitssensor (1) gemäß einem der Ansprüche 1 bis 9, ferner umfassend ein integriertes Schaltungselement (7), das auf einer zweiten Oberfläche (21b) des Substratteils (21) angebracht ist, die der ersten Oberfläche (21a) gegenüberliegt, und das elektrisch mit dem ersten axialen Element (5X), dem zweiten axialen Element (5Y) und dem dritten axialen Element (5Z) verbunden ist.

## Revendications

1. Capteur multiaxial de vitesse angulaire (1), comprenant :
un boîtier (11) comprenant une partie à substrat (21), la partie à substrat (21) comprenant une première surface (21a) perpendiculaire à un troisième axe (D3) parmi un premier axe (D1), un deuxième axe (D2), et le troisième axe (D3) qui sont perpendiculaires les uns aux autres, un bord extérieur de la première surface (21a) comprenant une paire de côtés longs (21c) parallèles au deuxième axe (D2) et une paire de côtés courts (21d) parallèles au premier axe (D1) ;
un premier élément axial (5X) qui est monté sur la première surface (21a) et est configuré pour détecter une vitesse angulaire sur un premier axe (D1) ;
un deuxième élément axial (5Y) qui est monté sur la première surface (21a) et est configuré pour détecter la vitesse angulaire sur le deuxième axe (D2) ; et
un troisième élément axial (5Z) qui est monté sur la première surface (21a) et est configuré pour détecter la vitesse angulaire sur le troisième axe (D3) ;
dans lequel chacun du premier élément axial (5X), du deuxième élément axial (5Y), et du troisième élément axial (5Z) comprend :
un corps piézoélectrique (51) comprenant une pluralité de bras (63, 65) s'étendant dans une direction prédéterminée d'extension dans une perspective de plan de la première surface (21a) et ayant la direction prédéterminée d'extension en tant que direction longue du corps piézoélectrique (51),
une électrode d'excitation (53A, 53B) sur une portion de la pluralité de bras (63), et
une électrode de détection (55) sur une autre portion de la pluralité de bras (65) ;
dans lequel deux éléments axiaux du premier élément axial (5X), du deuxième élément axial (5Y), et du troisième élément axial (5Z) sont agencés côte-à-côte dans une direction le long de la paire de côtés courts (21d) avec des orientations pour que la direction d'extension de chacun des deux éléments axiaux soit parallèle à la paire de côtés longs (21c), et un élément axial restant du premier élément axial (5X), du deuxième élément axial (5Y), et du troisième élément axial (5Z) est agencé dans une direction le long de la paire de côtés longs (21c) relativement aux deux éléments axiaux avec une orientation pour que la direction d'extension soit parallèle à la paire de côtés courts (21d), ou
trois éléments axiaux du premier élément axial (5X), du deuxième élément axial (5Y), et du troisième élément axial (5Z) sont agencés côte-à-côte dans des directions le long de la paire de côtés longs (21c) avec des orientations pour que les directions d'extension deviennent parallèles à la paire de côtés courts (21d) ; et
**caractérisé en ce que**
la partie à substrat (21) comprend un motif de potentiel de référence (87G) qui est partagé par le premier élément axial (5X), le deuxième élément axial (5Y), et le troisième élément axial (5Z).

2. Capteur multiaxial de vitesse angulaire (1) selon la revendication 1, dans lequel
dans chacun du premier élément axial (5X), du deuxième élément axial (5Y), et du troisième élément axial (5Z),
le corps piézoélectrique (51) comprend une portion de cadre (71) entourant la pluralité de bras (63, 65) dans la perspective de plan de la première surface (21a), et
la portion de cadre (71) est de forme rectangulaire ayant la direction prédéterminée d'extension en tant que direction longue.

3. Capteur multiaxial de vitesse angulaire (1) selon la revendication 1 ou 2, dans lequel le capteur multiaxial de vitesse angulaire (1) comprend les deux éléments axiaux du premier élément axial (5X), du deuxième élément axial (5Y), et du troisième élément axial (5Z) agencés côte-à-côte dans une direction le long de la paire de côtés courts (21d) avec les orientations pour que la direction d'extension de chacun des deux éléments axiaux soit parallèle à la paire de côtés longs (21c), et l'élément axial restant du premier élément axial (5X), du deuxième élément axial (5Y), et du troisième élément axial (5Z) est agencé dans la direction le long de la paire de côtés longs (21c) relativement aux deux éléments axiaux avec l'orientation pour que la direction d'extension soit parallèle à la paire de côtés courts (21d).

4. Capteur multiaxial de vitesse angulaire (1) selon la revendication 3, dans lequel un des deux éléments axiaux et de l'élément axial restant est configuré pour détecter des vitesses angulaires sur des axes parallèles à la direction d'extension ou des vitesses angulaires sur des axes perpendiculaires à la direction d'extension.

5. Capteur multiaxial de vitesse angulaire (1) selon l'une quelconque des revendications 1 à 4, dans lequel les corps piézoélectriques (51) dans le premier élément axial (5X), le deuxième élément axial (5Y), et le troisième élément axial (5Z) sont séparés les uns des autres.

6. Capteur multiaxial de vitesse angulaire (1) selon l'une quelconque des revendications 1 à 4, dans lequel les corps piézoélectriques (51) dans au moins les deux éléments axiaux du premier élément axial (5X), du deuxième élément axial (5Y), et du troisième élément axial (5Z), dans lesquels les directions d'extension sont parallèles l'uns à l'autre, sont formés de façon monobloc.

7. Capteur multiaxial de vitesse angulaire (1) selon la revendication 3 ou 4, dans lequel
en ce qui concerne chacun du premier élément axial (5X), du deuxième élément axial (5Y), et du troisième élément axial (5Z), le boîtier (11) comprend, sur la première surface,
une paire de plots de conduction (15D-1, 15D-2) qui sont électriquement connectés à une pluralité d'électrodes d'excitation (53A, 53B), et
une paire de plots de détection (15S) qui sont électriquement connectés à une pluralité d'électrode de détections (55),
sur un élément des deux éléments axiaux agencés côte-à-côte dans la direction le long de la paire de côtés courts (21d), qui est situé sur un côté plus près d'un de la paire de côtés longs (21c), la paire de plots de détection (15S) sont situés sur un côté plus près de l'un de la paire de côtés longs (21c) qu'au moins un de la paire de plots de conduction (15D-1, 15D-2), et sont agencés le long de l'un de la paire de côtés longs (21c),
sur un autre élément des deux éléments axiaux agencés côte-à-côte dans la direction le long de la paire de côtés courts (21d), qui est situé sur un côté plus près d'une autre de la paire de côtés longs (21c), la paire de plots de détection (15S) sont situés sur un côté plus près de l'autre de la paire de côtés longs (21c) qu'au moins un de la paire de plots de conduction (15D-1, 15D-2), et sont agencés le long de l'autre de la paire de côtés longs (21c), et
sur l'élément axial restant situé sur un côté plus près d'un de la paire de côtés courts (21d) relativement aux deux éléments axiaux, la paire de plots de détection (15S) sont situés sur un côté plus près de l'un de la paire de côtés courts (21d) qu'au moins un de la paire de plots de conduction (15D-1, 15D-2), et sont agencés le long de l'un de la paire de côtés courts (21d) .

8. Capteur multiaxial de vitesse angulaire (1) selon la revendication 7, dans lequel
le boîtier (11) comprend une couche de conducteur parallèle à la première surface (21a) dans une portion interne de la partie à substrat (21),
la couche de conducteur comprend, en ce qui concerne chacun du premier élément axial (5X), du deuxième élément axial (5Y), et du troisième élément axial (5Z),
une paire de câblages de conduction (87D-1, 87D-2) qui sont électriquement connectés à la paire de plots de conduction (15D-1, 15D-2), et
une paire de câblages de détection (87S) qui sont électriquement connectés à la paire de plots de détection (15S), et
la couche de conducteur comprend en outre le motif de potentiel de référence (87G) situé entre un câblage de conduction, de la paire de câblages de conduction (87D-1, 87D-2), qui est connecté à l'au moins un de la paire de plots de conduction (15D-1, 15D-2), et la paire de câblages de détection (87S), dans chacun du premier élément axial (5X), du deuxième élément axial (5Y), et du troisième élément axial (5Z).

9. Capteur multiaxial de vitesse angulaire (1) selon la revendication 8, dans lequel la paire de câblages de détection (87S) sont électriquement connectés à la paire de plots de détection (15S) à des positions immédiatement en dessous de la paire de plots de détection (15S) et s'étendent depuis les positions immédiatement en dessous vers un bord extérieur de la partie à substrat (21).

10. Capteur multiaxial de vitesse angulaire (1) selon l'une quelconque des revendications 1 à 9, comprenant en outre un élément à circuit intégré (7) qui est monté sur une seconde surface (21b) de la partie à substrat (21) qui est opposée à la première surface (21a), et est électriquement connecté au premier élément axial (5X), au deuxième élément axial (5Y), et au troisième élément axial (5Z).
